# EUROPEAN PATENT APPLICATION

(11) **EP 4 141 933 A1**
(43) Date of publication of application: **01.03.2023**
(21) Application number: 20939197.8
(22) Date of filing: 30.05.2020
(51) Int. Cl.: H01L 27/11514, H01L 27/11597

(54) **FERROELECTRIC RANDOM ACCESS MEMORY AND MANUFACTURING METHOD THEREFOR, AND ELECTRONIC DEVICE**

(71) Applicant: Huawei Technologies Co., Ltd., Longgang District, Shenzhen, Guangdong 518129 (CN)
(72) Inventor: YANG, Xichao, Shenzhen, Guangdong 518129 (CN); WANG, Xiaowei, Shenzhen, Guangdong 518129 (CN); QIN, Jianying, Shenzhen, Guangdong 518129 (CN); ZHANG, Yan, Shenzhen, Guangdong 518129 (CN); WEI, Xia, Shenzhen, Guangdong 518129 (CN)
(74) Representative: MERH-IP Matias Erny Reichl Hoffmann Patentanwälte PartG mbB
(86) International application number: PCT/CN2020/093607
(87) International publication number: WO 2021/243484

(57) **Abstract**

A ferroelectric memory and a fabrication method therefor, and an electronic device are provided, and relate to the field of storage technologies, to alleviate the problem that the number of process steps and costs increase as the number of stacked FRAMs increases. The ferroelectric memory includes a substrate and S memory cell arrays. The S memory cell arrays may be sequentially arranged on the substrate along a first direction parallel to the substrate. A trench is provided between two adjacent memory cell arrays. When the foregoing ferroelectric memory is fabricated, a composite stacked structure may be fabricated on the substrate, and then a plurality of trenches extending through the composite stacked structure may be fabricated in a same fabrication process. Next, M bit lines may be fabricated in the same fabrication process. Then, N first interlayer word lines are fabricated on in the same fabrication process, to complete the fabrication of the S memory cell arrays at the same time.

## Description

### TECHNICAL FIELD

This application relates to the field of storage technologies, and in particular, to a ferroelectric memory and a fabrication method therefor, and an electronic device.

### BACKGROUND

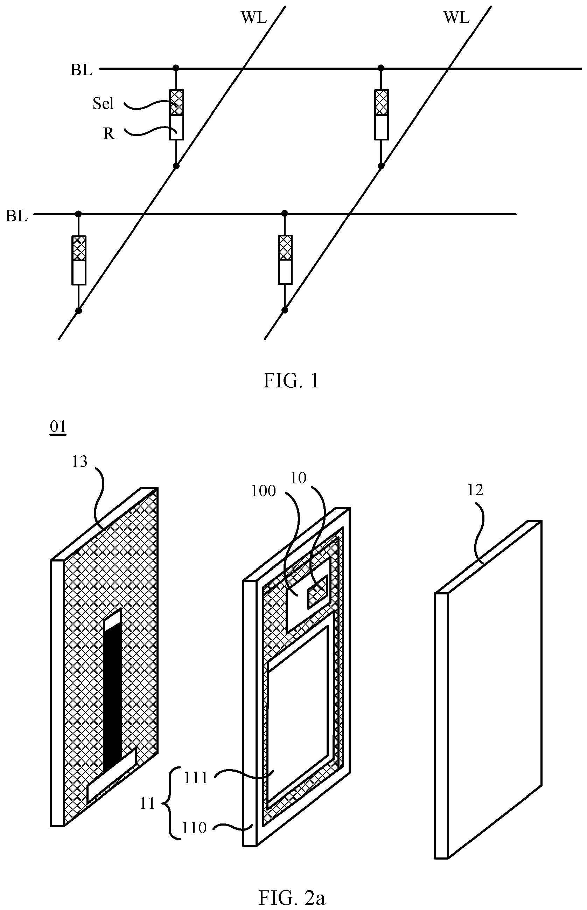

A ferroelectric random access memory (ferroelectric random access memory, FRAM) can utilize the spontaneous polarization phenomenon in a ferroelectric material to implement data storage. In order to increase a storage capacity of a FRAM, an existing FRAM may use a crossbar (crossbar) array structure. The crossbar array structure, as shown in FIG. 1, has a plurality of word lines (word line, WL) and a plurality of bit lines (bit line, BL). One memory cell is provided at the intersection of one WL and one BL, and the memory cell may include a two-terminal selector (selector, Sel) on a substrate and an information storage resistor R electrically connected to the selector. The connected selector Sel can be selected through regulation of a voltage between the WL and the BL, to perform a read or write operation on the information storage resistor R.

When crossbar array structures described above are three-dimensionally stacked along a direction perpendicular to the substrate, process steps such as photolithography, etching, deposition, and metal interconnect are required for each individual layer of memory cells. These process steps need to be repeated for each layer of memory cells as the stacking progresses. Therefore, as more FRAM layers are stacked, process costs increase rapidly.

### SUMMARY

Embodiments of this application provide a ferroelectric memory and a fabrication method therefor, and an electronic device, to alleviate the problem that the number of process steps and costs increase as the number of stacked FRAMs increases.

To achieve the foregoing objective, the following technical solutions are used in this application.

A first aspect of the embodiments of this application provides a ferroelectric memory. The ferroelectric memory includes a substrate and S memory cell arrays, where S ≥ 2, and S is a positive integer. The S memory cell arrays may be sequentially arranged on the substrate along a first direction parallel to the substrate. A trench is provided between two adjacent memory cell arrays. Each memory cell array includes N stacked structures and M bit lines. The N stacked structures are sequentially stacked along a second direction perpendicular to the substrate. Each stacked structure includes a composite layer and a first interlayer word line. The composite layer includes a first interlayer dielectric layer and a ferroelectric material layer that are stacked. The first interlayer word line is disposed along a third direction and is in contact with the first interlayer dielectric layer and the ferroelectric material layer. The third direction is parallel to the substrate and perpendicular to the first direction, where N ≥ 2, and N is an integer. Each of the M bit lines extends through the composite layers of the N stacked structures along the second direction, where M ≥ 2, and M is an integer. In conclusion, in the memory cell array, one first interlayer word line, one bit line, and a part of the ferroelectric material layer between the first interlayer word line and the bit line may constitute one first memory cell. The first memory cell can perform a read or write operation on data. Based on this, it can be learned from the above that each of the memory cell arrays may include N stacked structures, and each stacked structure may include one first interlayer word line. In addition, each memory cell array further includes M bit lines. Therefore, each memory cell array in the ferroelectric memory provided in this embodiment of this application may include N×M first memory cells. The ferroelectric memory has the S memory cell arrays, the S memory cell arrays are sequentially arranged on the substrate along the first direction, and two adjacent memory cell arrays are spaced apart by a trench, to be independent of each other. Therefore, the first memory cells in the ferroelectric memory are arranged in an S×N×M three-dimensional array. In this way, during the fabrication of one memory cell array having N×M first memory cells on the substrate along the second direction perpendicular to the substrate, the remaining S-1 memory cell arrays (each of the memory cell arrays has N×M first memory cells) are fabricated on the substrate at the same time. In this way, it is possible to avoid repeating a set of processes such as photolithography, etching, deposition, and metal interconnect for the fabrication of each memory cell array, thereby simplifying fabrication processes. In this case, even if the number of the memory cell arrays in the ferroelectric memory increases, because the S memory cell arrays can be fabricated at the same time, the increase in the number of the memory cell arrays in the ferroelectric memory does not cause an increase in the number of process steps of all single layers, thereby reducing costs.

Optionally, the stacked structure further includes a second interlayer word line. The second interlayer word line is disposed along a third direction and is in contact with the first interlayer dielectric layer and the ferroelectric material layer. The first interlayer word line and the second interlayer word line are respectively located on two sides of the composite layer along the first direction. In this case, one second interlayer word line, one bit line, and a part of the ferroelectric material layer, in each second memory cell, between the second interlayer word line and the bit line may constitute the second memory cell. The second memory cell can perform a read or write operation on data. Each memory cell array has N×M second memory cells. In this way, one first memory cell and one second memory cell in the same layer of stacked structure can share one bit line. This can simplify the structure of the ferroelectric memory while improving the storage capacity of the ferroelectric memory.

Optionally, a first stepped structure is formed at one end of the N stacked structures along the third direction, and a second stepped structure at the other end. The lengths of the N stacked structures decrease sequentially along the direction away from the substrate. The length direction of the stacked structure is parallel to the third direction. In this case, for two adjacent stacked structures on the substrate, the length of the upper stacked structure is less than the length of the lower stacked structure, so that a part of each of the first interlayer word line and the second interlayer word line in each layer of stacked structure can be exposed, without being blocked by the composite layer of an upper layer of stacked structure. In addition, the memory cell array further includes N first word line vias and N second word line vias. The N first word line vias are electrically connected to the first interlayer word lines in N steps of the first stepped structure, respectively. The N second word line vias are electrically connected to the second interlayer word lines in N steps of the second stepped structure, respectively. In addition, the ferroelectric memory further includes N first global word lines and N second global word lines. The N first global word lines are electrically connected to the N first word line vias of each memory cell array, respectively. The N second global word lines may be electrically connected to the N second word line vias of each memory cell array, respectively. In this way, the first interlayer word lines electrically connected to the plurality of first memory cells can be led out from the first word line vias. The second interlayer word lines electrically connected to the plurality of second memory cells can be led out from the second word line vias. Each first global word line may provide a strobe signal to the first word line vias located on the same step in each memory cell array. Each second global word line may provide a strobe signal to the second word line vias located on the same step in each memory cell array. In this way, the first global word line and the second global word line can respectively control the first memory cell and the second memory cell in the same memory cell array.

Optionally, the first stepped structure is formed at one end of the N stacked structures along the third direction. The lengths of the N stacked structures decrease sequentially along the direction away from the substrate. The length direction of the stacked structure is parallel to the third direction. In this case, the length of the upper stacked structure is less than the length of the lower stacked structure, so that a part of each of the first interlayer word line and the second interlayer word line in each layer of stacked structure can be exposed, without being blocked by the composite layer of an upper layer of stacked structure. In addition, the memory cell array further includes N first word line vias and N second word line vias. The N first word line vias are electrically connected to the first interlayer word lines in N steps of the first stepped structure, respectively. The N second word line vias are electrically connected to the second interlayer word lines in N steps of the first stepped structure, respectively. In addition, the ferroelectric memory further includes N first global word lines. The N first global word lines are electrically connected to the N first word line vias of each memory cell array, respectively. The N first global word lines are further electrically connected to the N second word line vias of each memory cell array, respectively. In this way, the first interlayer word lines electrically connected to the plurality of first memory cells can be led out from the first word line vias. The second interlayer word lines electrically connected to the plurality of second memory cells can be led out from the second word line vias. Each first global word line may provide a strobe signal to the first word line vias located on the same step in each memory cell array. Each first global word line may further provide a strobe signal to the second word line vias located on the same step in each memory cell array. In this way, the first memory cell and the second memory cell located in the same layer in each memory cell array can be electrically connected by using the first global word line. In this case, both the memory cell array composed of the plurality of first memory cells and the memory cell array composed of the plurality of second memory cells can work, and the direction of polarization of the ferroelectric material layer does not need to be obtained in advance, thereby lowering requirements for the direction of polarization of the ferroelectric material layer.

Optionally, the first stepped structure is formed at one end of the N stacked structures along the third direction. The lengths of the N stacked structures decrease sequentially along the direction away from the substrate. The length direction of the stacked structure is parallel to the third direction. In this case, the length of the upper stacked structure is less than the length of the lower stacked structure, so that a part of each of the first interlayer word line and the second interlayer word line in each layer of stacked structure can be exposed, without being blocked by the composite layer of an upper layer of stacked structure. In addition, the memory cell array further includes N first word line vias. The N first word line vias are electrically connected to the first interlayer word lines in N steps of the first stepped structure, respectively. The ferroelectric memory further includes N first global word lines. The N first global word lines are electrically connected to the N first word line vias of each memory cell array, respectively. The technical effects of the first word line via and the first global word line are the same as those described above, and details are not repeated herein.

Optionally, the stacked structure has a first groove. The first groove is provided on the composite layer along the third direction. The first interlayer word line is located in the first groove. In this way, a plurality of first grooves can be formed on a plurality of stacked structures by using the same fabrication process. Then, the first interlayer word lines are fabricated in the first grooves in the same fabrication process. In this way, the fabrication process is simplified.

Optionally, the first groove is provided on the first interlayer dielectric layer, a surface of the first interlayer word line parallel to the substrate is in contact with the ferroelectric material layer, and a surface of the first interlayer word line parallel to the second direction is in contact with the first interlayer dielectric layer. A wet etching process may be used to remove a part of the first interlayer dielectric layer to form the first groove.

Optionally, the composite layer further includes a second interlayer dielectric layer. The second interlayer dielectric layer is disposed between the first interlayer dielectric layer and the ferroelectric material layer, and is in contact with the first interlayer dielectric layer, the ferroelectric material layer, and the first interlayer word line. In this way, two adjacent ferroelectric material layers can be spaced apart by the second interlayer dielectric layer, so avoid crosstalk between electrical signals of two upper and lower first memory cells. In addition, a material of the first interlayer dielectric layer is different from that of the second interlayer dielectric layer, which can avoid affecting the structure of the second interlayer dielectric layer when the first interlayer dielectric layer is wet-etched.

Optionally, the first groove is provided on the ferroelectric material layer, a surface of the first interlayer word line parallel to the substrate is in contact with the first interlayer dielectric layer, and a surface of the first interlayer word line parallel to the second direction is in contact with the ferroelectric material layer. A wet etching process may be used to remove a part of the ferroelectric material layer to form the first groove.

Optionally, the stacked structure has a second groove. The second groove is provided on the composite layer along the third direction. The first groove and the second groove are respectively located on two sides of the composite layer along the third direction. The second interlayer word line is located in the second groove. In this way, the fabrication of the plurality of second grooves can be completed while the first grooves are fabricated on the plurality of stacked structures by using the same fabrication process. Then, the fabrication of the plurality of second interlayer word lines in the second grooves can be completed while the first interlayer word lines are fabricated in the first grooves in the same fabrication process. In this way, the fabrication process is simplified.

Optionally, the substrate may include a semiconductor substrate, an isolation dielectric layer, an etching barrier layer, and S×M metal plugs. The control circuit is provided in the semiconductor substrate. The isolation dielectric layer covers the semiconductor substrate. The etching barrier layer covers the isolation dielectric layer. The metal plugs extend through the isolation dielectric layer and are configured to electrically connect the control circuit to a bit line. In this way, during the fabrication of the ferroelectric memory, the metal plugs may be first formed on the semiconductor substrate, and then are covered by the etching barrier layer. The etching barrier layer can protect the semiconductor substrate to prevent the subsequent steps from damaging the semiconductor substrate. In addition, the bit lines fabricated in the subsequent steps can be electrically connected to the control circuit on the semiconductor substrate through the metal plugs.

Optionally, a material of the first interlayer dielectric layer includes oxide. A material of the ferroelectric material layer includes: lithium niobate, lithium tantalate, bismuth ferrite, lead zirconate titanate, barium titanate, strontium tantalate, hafnium dioxide, or the like.

Optionally, the ferroelectric memory further includes a fill dielectric layer covering the S memory cell arrays and the substrate. The first word line vias and the second word line vias extend through the fill dielectric layer along the second direction. The first global word lines and the second global word lines are provided on may be provided on an outer surface of the fill dielectric layer parallel to the substrate. The fill dielectric layer can protect the S memory cell arrays.

Optionally, a material of the fill dielectric layer is the same as the material of the first interlayer dielectric layer, which can simplify the fabrication process.

A second aspect of the embodiments of this application provides an electronic device, including a circuit board and any one of the foregoing ferroelectric memories provided on the circuit board. The electronic device has the same technical effects as the foregoing embodiment, and details are not repeated herein.

A third aspect of the embodiments of this application provides a fabrication method for a ferroelectric memory. The fabrication method includes the following steps: First, a plurality of first interlayer dielectric layers and a plurality of ferroelectric material layers are alternately stacked in sequence on a substrate along a second direction perpendicular to the substrate, to form a composite stacked structure. Next, S×M vias extending through the composite stacked structure are formed as bit lines, where S ≥ 2, M ≥ 2, and S and M are integers. Next, S-1 trenches extending through the composite stacked structure and arranged along a first direction parallel to the substrate are formed. The composite stacked structure is partitioned into S sub-composite stacked structures by the S-1 trenches. M bit lines extend through each sub-composite stacked structure. N first interlayer word lines arranged along the second direction are formed on a first side of each trench. Each first interlayer word line is disposed along a third direction and is in contact with the first interlayer dielectric layer and the ferroelectric material layer. N ≥ 2, and N is an integer. The third direction is parallel to the substrate, and is perpendicular to the first direction. In this way, during the fabrication of the ferroelectric memory, the plurality of alternately stacked first interlayer dielectric layers and ferroelectric material layers may be fabricated on the substrate, forming the composite stacked structure. Then, the plurality of trenches extending through the composite stacked structure may be fabricated along the second direction in the same fabrication process, and the composite stacked structure is partitioned into the N sub-composite stacked structures through the plurality of trenches. Next, M bit lines extending through each sub-composite stacked structure may be fabricated on the sub-composite stacked structure along the second direction in the same fabrication process. Next, N first interlayer word lines are fabricated on each sub-composite stacked structure along the third direction in the same fabrication process, thereby completing the fabrication of the S memory cell arrays. Therefore, during the fabrication of one memory cell array on the substrate, the remaining S-1 memory cell arrays can be fabricated on the substrate at the same time. In this way, it is possible to avoid repeating a set of processes such as photolithography, etching, deposition, and metal interconnect for each memory cell array, thereby simplifying fabrication processes. In this case, even if the number of the memory cell arrays in the ferroelectric memory increases, because the S memory cell arrays can be fabricated at the same time, the increase in the number of the memory cell arrays in the ferroelectric memory does not cause an increase in the number of process steps, thereby reducing costs.

Optionally, before the N first interlayer word lines arranged along the second direction are formed on the first side of each trench, the fabrication method further includes: removing a part of the material of the plurality of first interlayer dielectric layers or the plurality of ferroelectric material layers on the first side of each trench, to form N first grooves arranged along the second direction. Each first groove is disposed along the third direction. The N first interlayer word lines arranged along the second direction being formed on the first side of each trench includes: filling each first groove with a metal material to form the first interlayer word lines. The technical effect of the first groove is the same as that described above, and details are not repeated herein.

Optionally, while the first groove is formed, the fabrication method further includes: removing a part of the material of the plurality of first interlayer dielectric layers or the plurality of ferroelectric material layers on a second side of each trench, to form N second grooves arranged along the second direction. Each second groove is disposed along the third direction. While the first interlayer word lines are formed, the fabrication method further includes: filling each second groove with a metal material to form N second interlayer word lines arranged along the second direction. The technical effect of the second groove is the same as that described above, and details are not repeated herein.

Optionally, before the trenches are formed, the method further includes: forming a first stepped structure at one end of the composite stacked structure along the third direction, and forming a second stepped structure at the other end at the same time. After the first interlayer word lines and the second interlayer word lines are formed, the method further includes the following steps: First, a fill dielectric layer is formed. Next, N first word line vias extending through at least the fill dielectric layer are formed on the side of the first stepped structure of each sub-composite stacked structure. The N first word line vias are electrically connected to the first interlayer word lines in N steps of the first stepped structure, respectively. In addition, N second word line vias extending through at least the fill dielectric layer are formed on the side of the second stepped structure of each sub-composite stacked structure. The N second word line vias are electrically connected to the second interlayer word lines in N steps of the second stepped structure, respectively. Next, N first global word lines and N second global word lines are formed on an outer surface of the fill dielectric layer parallel to the substrate. The N first global word lines are electrically connected to the N first word line vias in each sub-composite stacked structure, respectively; and the N second global word lines are electrically connected to the N second word line vias in each sub-composite stacked structure, respectively. The technical effects of the first word line via, the second word line via, the first global word line, and the second global word line are the same as those described above, and details are not repeated herein.

### BRIEF DESCRIPTION OF DRAWINGS

FIG. 1 is a schematic diagram of a structure of a memory according to the related art;
FIG. 2a is a schematic diagram of a structure of an electronic device according to an embodiment of this application;
FIG. 2b is a schematic diagram of a structure of a ferroelectric memory according to an embodiment of this application;
FIG. 2c is a schematic diagram of a structure of a memory cell array in FIG. 2b;
FIG. 2d is another schematic diagram of a structure of a memory cell array in FIG. 2b;
FIG. 3 is a schematic diagram of a structure of a ferroelectric memory during fabrication according to an embodiment of this application;
FIG. 4a is another schematic diagram of a structure of a memory cell array in FIG. 2b;
FIG. 4b is a schematic diagram of polarization of a ferroelectric material in a ferroelectric memory according to an embodiment of this application;
FIG. 4c is another schematic diagram of polarization of a ferroelectric material in a ferroelectric memory according to an embodiment of this application;
FIG. 5a is another schematic diagram of a structure of a ferroelectric memory during fabrication according to an embodiment of this application;
FIG. 5b is another schematic diagram of a structure of a ferroelectric memory during fabrication according to an embodiment of this application;
FIG. 6a is another schematic diagram of a structure of a memory cell array in FIG. 2b;
FIG. 6b is a schematic diagram of a structure of a first memory cell and a second memory cell in the memory cell array in FIG. 6a;
FIG. 6c is a schematic diagram of a structure of a first groove and a second groove according to an embodiment of this application;
FIG. 7 is another schematic diagram of a structure of a first memory cell and a second memory cell in the memory cell array in FIG. 6a;
FIG. 8a is another schematic diagram of a structure of a first groove and a second groove according to an embodiment of this application;
FIG. 8b is another schematic diagram of a structure of a first memory cell and a second memory cell in the memory cell array in FIG. 6a;
FIG. 9 is a sectional view taken along a dashed line E-E in FIG. 2c;
FIG. 10a is a schematic diagram of a structure of another ferroelectric memory according to an embodiment of this application;
FIG. 10b is a schematic diagram of a partial structure in FIG. 10a;
FIG. 10c is another schematic diagram of a partial structure in FIG. 10a;
FIG. 10d is a top view of FIG. 1 0a;
FIG. 11a is a schematic diagram of a structure of another ferroelectric memory according to an embodiment of this application;
FIG. 11b is a top view of FIG. 11a;
FIG. 11c is a schematic diagram of a structure of another ferroelectric memory according to an embodiment of this application;
FIG. 12 is a flowchart of a fabrication method for a ferroelectric memory according to an embodiment of this application;
FIG. 13a is a schematic diagram of a structure corresponding to performing S101 in FIG. 12;
FIG. 13b is a schematic diagram of a structure corresponding to performing S102 in FIG. 12;
FIG. 14a, FIG. 14b, and FIG. 14c are schematic diagrams of structures corresponding to performing S103 in FIG. 12;
FIG. 15a and FIG. 15b are schematic diagrams of structures corresponding to performing S104 in FIG. 12;
FIG. 16 is a schematic diagram of a structure corresponding to performing S105 in FIG. 12;
FIG. 17a and FIG. 17b are schematic diagrams of structures corresponding to performing S106 in FIG. 12;
FIG. 18a, FIG. 18b, and FIG. 18c are schematic diagrams of structures corresponding to performing S107 in FIG. 12;
FIG. 19 is a schematic diagram of a structure corresponding to performing S108 in FIG. 12;
FIG. 20a is a schematic diagram of a structure of another ferroelectric memory according to an embodiment of this application;
FIG. 20b is a schematic diagram of a stepped structure according to an embodiment of this application;
FIG. 20c is a schematic top view of a structure of a ferroelectric memory according to an embodiment of this application;
FIG. 20d is a schematic diagram of a structure of another ferroelectric memory according to an embodiment of this application;
FIG. 21a is a schematic diagram of a structure of another ferroelectric memory according to an embodiment of this application; and
FIG. 21b is a schematic diagram of a structure of another ferroelectric memory according to an embodiment of this application.

Reference numerals:
01. electronic device; 11. middle frame; 110. bearing plate; 111. frame; 12. back cover; 13. display; 10. ferroelectric memory; 20. memory cell array; 21. trench; 201. first memory cell; 202. second memory cell; 100. substrate; 30. stacked structure; BL. bit line; WL11. first interlayer word line; 22. composite stacked structure; 300. composite layer; 301. first interlayer dielectric layer; 302. ferroelectric material layer; 303. second interlayer dielectric layer; 221. sub-composite stacked structure; WL12. second interlayer word line; 31. first groove; 32. second groove; 51. first stepped structure; 52. second stepped structure; 61. first word line via; 62. second word line via; 70. fill dielectric layer; WL21. first global word line; WL22. second global word line; 101. semiconductor substrate; 102. isolation dielectric layer; 103. etching barrier layer; 104. metal plug; 200. mask layer; 71. material layer; and 72. metal material.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms "first" and "second" mentioned below are merely intended for a purpose of description, and shall not be understood as an indication or implication of relative importance or implicit indication of the number of indicated technical features. Therefore, a feature limited by "first" or "second" may explicitly indicate or implicitly include one or more such features. In the descriptions of this application, unless otherwise stated, "a plurality of" means two or more than two.

In addition, in the embodiments of this application, "upper", "lower", "left", and "right" are not necessarily defined relative to orientations in which components are schematically placed in the accompanying drawings. It should be understood that these orientation terms may be relative concepts for relative description and clarification, and may change accordingly based on changes of the orientations in which the components are placed in the accompanying drawings.

In this application, the term "connection" should be interpreted in a broad sense unless explicitly specified and defined otherwise. For example, the "connection" may be a fixed connection, a detachable connection, or an integral connection; or may be a direct connection or an indirect connection through an intermediary. In addition, the term "electrical connection" may be a direct electrical connection or an indirect electrical connection through an intermediary.

An embodiment of this application provides an electronic device. The electronic device may include a mobile phone (mobile phone), a tablet computer (pad), a television, a smart wearable product (such as a smart watch or a smart band), a virtual reality (virtual reality, VR) terminal device, an augmented reality (augmented reality, AR) terminal device, a small household appliance (such as a soy milk maker or a robot vacuum cleaner) capable of charging, an uncrewed aerial vehicle, or another electronic product. A specific form of the electronic device is not specially limited in the embodiments of this application. Any of the foregoing electronic devices is, for example, a mobile phone. As shown in FIG. 2a, the electronic device 01 may include a middle frame 11, a back cover 12, and a display 13. The middle frame 11 includes a bearing plate 110 for carrying the display 13, and a frame 111 surrounding the bearing plate 110. The electronic device 01 may include a circuit board, such as a printed circuit board (printed circuit boards, PCB), provided on the surface of the bearing plate 110 facing the back cover 12 and some electronic components, such as a ferroelectric random access memory, hereinafter briefly referred to as a ferroelectric memory 10, provided on the circuit board. The back cover 12 is connected to the middle frame 11, which can prevent external water vapor and dust from affecting performance of the circuit board and the electronic components.

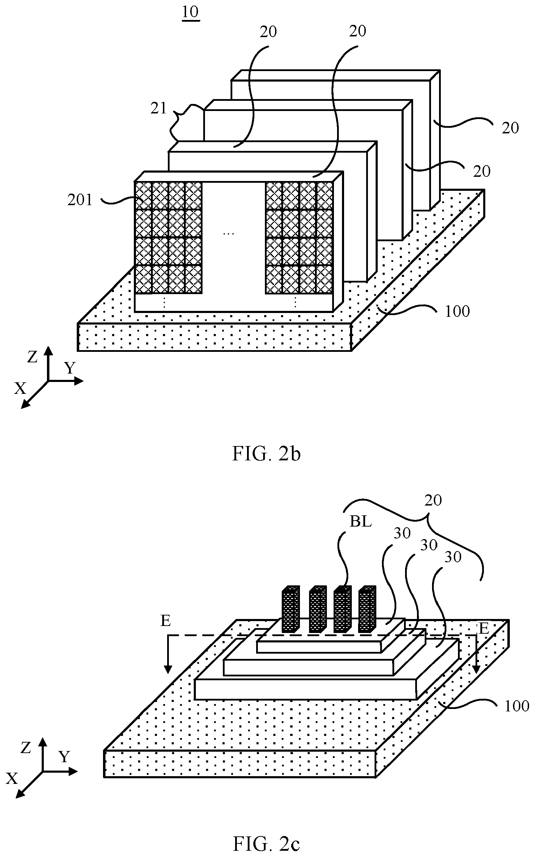

The ferroelectric memory 10 provided in an embodiment of this application, as shown in FIG. 2b, may include a substrate 100 and S memory cell arrays 20 that are sequentially arranged on the substrate 100 along a first direction X parallel to the substrate 100. A trench (trench) 21 is provided between two adjacent memory cell arrays 20. The trench 21 can space apart two adjacent memory cell arrays 20 as two independent memory cell arrays 20.

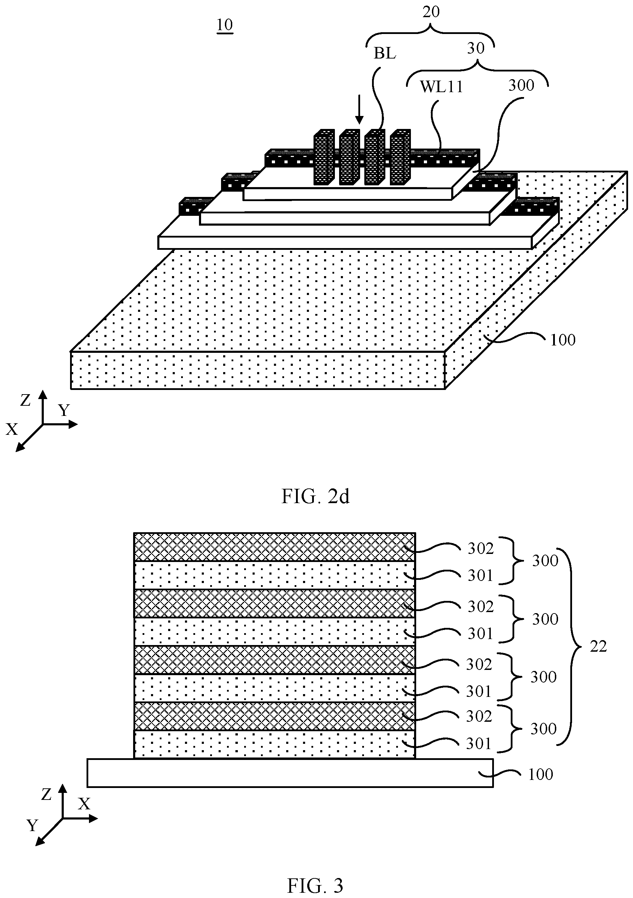

Based on this, as shown in FIG. 2c, each of the memory cell arrays 20 may include N stacked structures 30 and M bit lines BL, where N ≥ 2, M ≥ 2, and N and N are integers. The N stacked structures 30 are sequentially stacked along a second direction Z perpendicular to the substrate 100. Each stacked structure 30 may include a composite layer 300 and a first interlayer word line WL11, as shown in FIG. 2d. Each bit line BL may extend through the composite layers 300 of the N stacked structures 30 along the second direction Z perpendicular to the substrate 100.

Each of the composite layers 300 of the memory cell arrays 20, as shown in FIG. 3, may include a first interlayer dielectric layer 301 and a ferroelectric material layer 302 that are stacked. In this case, a plurality of first interlayer dielectric layers 301 and a plurality of ferroelectric material layers 302 in the N stacked structures 30 may be alternately stacked on the substrate 100 along the second direction Z. In each composite layer 300, the first interlayer dielectric layer 301 may be disposed closer to the substrate 100 than the ferroelectric material layer 302.

In some embodiments of this application, a material of the first interlayer dielectric layer 301 may include oxide, such as silicon oxide. A material of the ferroelectric material layer 302 may include: lithium niobate (LiNbO3), blackened lithium niobate, doped lithium niobate, lithium tantalate (LiTaO3), blackened lithium tantalate, doped lithium tantalate, bismuth ferrite (BiFeO3), doped bismuth ferrite, lead zirconate titanate (piezoelectric ceramic transducer, PZT), doped lead zirconate titanate, barium titanate (BaTiO3), doped barium titanate, strontium tantalate, doped strontium tantalate, hafnium dioxide (HfO2), zirconium-doped hafnium dioxide, silicon-doped hafnium dioxide, or the like. A dopant for the doped lithium niobate or the doped lithium tantalate may include one or more of magnesium oxide (MgO), iron (Fe), manganese (Mn), erbium (Er), titanium (Ti), or the like. A concentration of MgO with which lithium niobate or lithium tantalate is doped may range from 0 mol% to 10 mol%.

In addition, as shown in FIG. 2d, the first interlayer word line WL11 may be disposed along a third direction Y, and may be in contact with the first interlayer dielectric layer 301 and the ferroelectric material layer 302 in the composite layer 300. The third direction Y may be parallel to the substrate 100 and perpendicular to the first direction X.

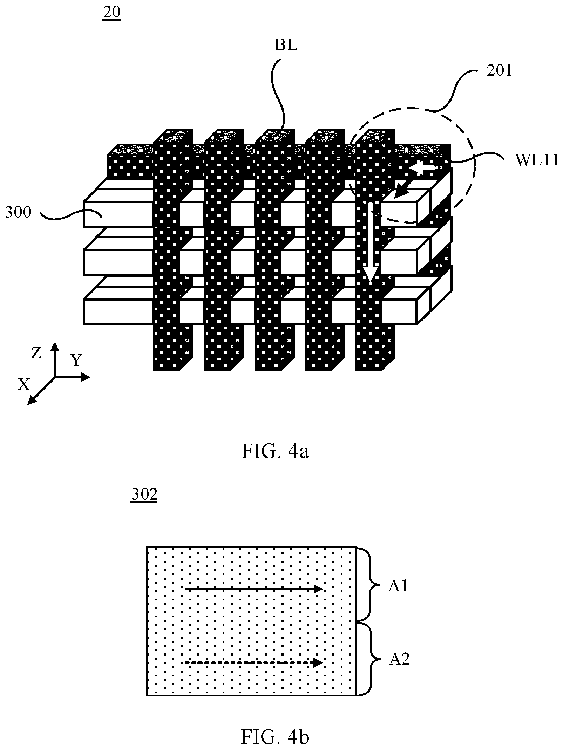

In conclusion, in the memory cell array 20, one first interlayer word line WL11, one bit line BL, and a part of the ferroelectric material layer 302 between the first interlayer word line WL11 and the bit line BL may constitute one first memory cell 201 (as shown in FIG. 2b). The first memory cell 201 can perform a read or write operation on data. Based on this, it can be learned from the above that each of the memory cell arrays 20 may include N stacked structures 30, and each stacked structure 30 may include one first interlayer word line WL11. In addition, each memory cell array 20 further includes M bit lines BLs. Therefore, each memory cell array 20 in the ferroelectric memory 10 provided in this embodiment of this application may include N×M first memory cells 201. In addition, it can be learned from the above that the S memory cell arrays 20 in the ferroelectric memory 10 are sequentially arranged on the substrate 100 along the first direction X. Therefore, the first memory cells 201 in the ferroelectric memory 10 are arranged in an S×N×M three-dimensional array. In this way, in a single memory cell array 20 shown in FIG. 4a, a control circuit may be used to apply an appropriate voltage to each first interlayer word line WL 11 and each bit line BL, so that a current (for example, the direction shown by the arrow in FIG. 4a) is generated in a first memory cell 201 in the memory cell array 20, and each first memory cell 201 in the memory cell array 20 may be selected for a read or write operation.

Specifically, after the voltage is applied to the bit line BL and the first interlayer word line WL11, different polarization states of the ferroelectric material between the bit line BL and the first interlayer word line WL11 cause the first memory cell 201 to have two states, namely, a high resistance state and a low resistance state, so that two states, namely, a low current and a high current, are respectively generated on the bit line BL during the read operation.

For example, in the case of applying the voltage to the bit line BL and the first interlayer word line WL 11, as shown in FIG. 4b, when a direction of polarization (shown by the solid arrow in FIG. 4b) of a ferroelectric material A1 between the bit line BL and the first interlayer word line WL11 is the same as a direction of polarization (shown by the dashed arrow in FIG. 4b) of a ferroelectric material A2 (not disposed between the bit line BL and the first interlayer word line WL11) adjacent to the ferroelectric material A1, the first memory cell 201 is in a high resistance state, and a low current is generated on the bit line BL. In this case, a sense amplifier (sense amplifier, SA) electrically connected to the bit line BL converts the low current into a digital signal "0" in a logical sense.

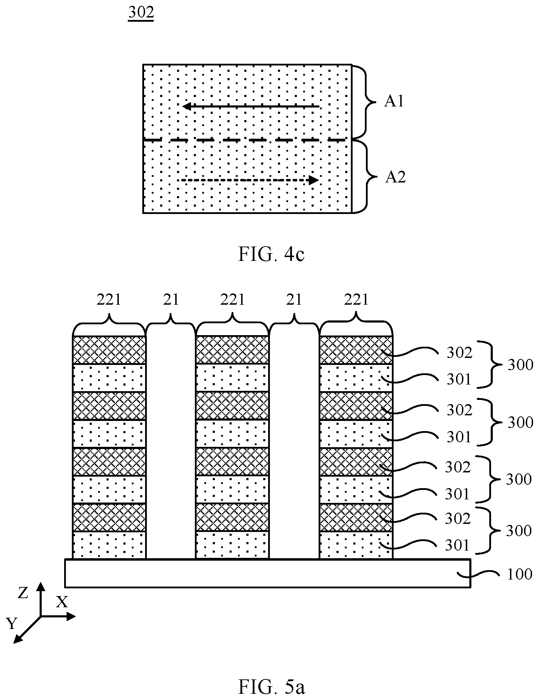

Alternatively, for another example, in the case of applying the voltage to the bit line BL and the first interlayer word line WL 11, as shown in FIG. 4c, when the direction of polarization (shown by the solid arrow in FIG. 4c) of the ferroelectric material A1 between the bit line BL and the first interlayer word line WL 11 is different from the direction of polarization (shown by the dashed arrow in FIG. 4c) of the ferroelectric material A2 adjacent to the ferroelectric material A1, a conduction channel is generated between the ferroelectric material A1 and the ferroelectric material A2 due to a domain wall conduction (domain wall conduction, DWC) phenomenon. In this case, the first memory cell 201 is in a low resistance state, and a high current is generated on the bit line BL. In this case, the SA electrically connected to the bit line BL converts the high current into a digital signal " 1" in a logical sense.

It can be learned from the above that the ferroelectric memory 10 has S memory cell arrays 20, and the S memory cell arrays 20 are sequentially arranged along the X direction on the substrate 100, so that a three-dimensional ferroelectric memory can be formed, thereby expanding a storage capacity of the ferroelectric memory.

In addition, in some embodiments of this application, the control circuit for providing the voltage terminal to the first interlayer word line WL 11 and the bit line BL may be fabricated in the substrate 100. In this case, the substrate 100 may include a semiconductor substrate, such as a silicon (Si) substrate. At least part of the control circuit may be fabricated in the semiconductor substrate through a semiconductor process. Alternatively, in some other embodiments of this application, the control circuit may be provided independently of the substrate 100. This application does not limit the manner of providing the control circuit.

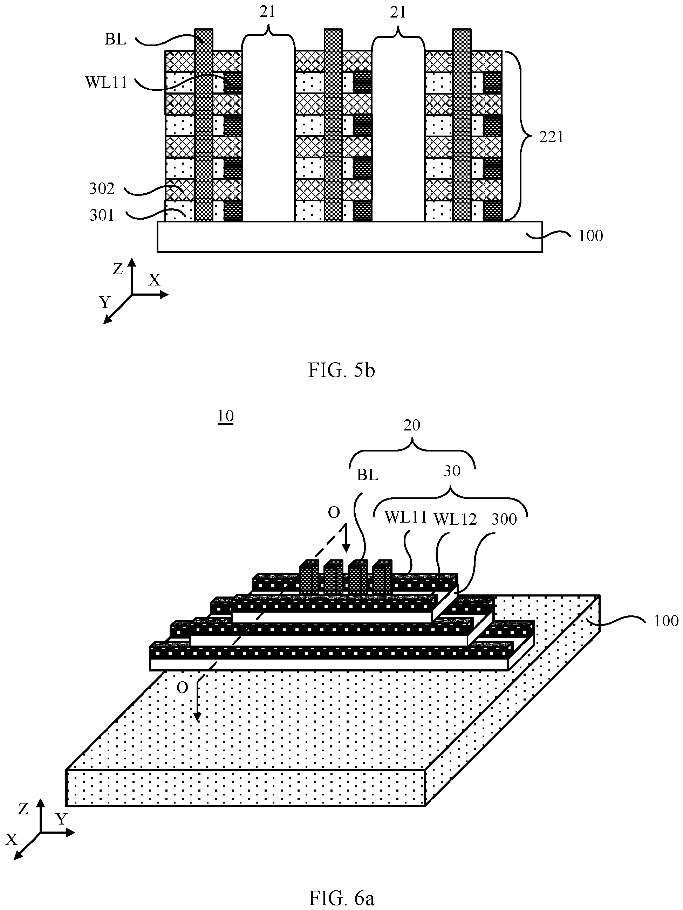

In addition, it can be learned from the above that, as shown in FIG. 2d, in each memory cell array 20 of the ferroelectric memory 10, N (for example, N = 3) first interlayer word lines WL11 are arranged along the second direction Z perpendicular to the substrate 100, and M (for example, M = 4) bit lines BLs are disposed along the second direction Z and arranged along the third direction Y parallel to the substrate 100. Therefore, in each memory cell array 20, each row (disposed in the third direction Y) of first memory cells 201 are stacked along the second direction Z. In addition, the S memory cell arrays 20 are arranged on the substrate 100 along the first direction X parallel to the substrate 100, and two adjacent memory cell arrays 20 are spaced apart by a trench 21. In this way, during the fabrication of the ferroelectric memory 10, as shown in FIG. 3, a plurality of alternately stacked first interlayer dielectric layers 301 and ferroelectric material layers 302 may be fabricated on the substrate 100, forming a composite stacked structure 22. Then, as shown in FIG. 5a, a plurality of trenches 21 extending through the composite stacked structure may be fabricated along the second direction Z in the same fabrication process, and the composite stacked structure is partitioned into N sub-composite stacked structures 221 through the plurality of trenches 21. Next, as shown in FIG. 5b, M bit lines BLs extending through each sub-composite stacked structure 221 may be fabricated on the sub-composite stacked structure 221 along the second direction Z in the same fabrication process. Next, N first interlayer word lines WL11 are fabricated on each sub-composite stacked structure 221 along the third direction Y in the same fabrication process, thereby completing the fabrication of the S memory cell arrays 20. Therefore, during the fabrication of one memory cell array 20 on the substrate 100, the remaining S-1 memory cell arrays 20 can be fabricated on the substrate 100 at the same time. In this way, it is possible to avoid repeating a set of processes such as photolithography, etching, deposition, and metal interconnect for each memory cell array 20, thereby simplifying fabrication processes. In this case, even if the number of the memory cell arrays 20 in the ferroelectric memory 10 increases, because the S memory cell arrays 20 can be fabricated at the same time, the increase in the number of the memory cell arrays 20 in the ferroelectric memory 10 does not cause an increase in the number of process steps of all single layers, thereby reducing costs.

Based on the structure of the ferroelectric memory 10 described above, other dispositions and fabrication processes of the ferroelectric memory 10 are described in detail below by using examples.

### Example 1:

In this example, as shown in FIG. 6a, each stacked structure 30 in each of the memory cell arrays 20 of the ferroelectric memory 10 may further include one second interlayer word line WL12, in addition to the composite layer 300 and one first interlayer word line WL11.

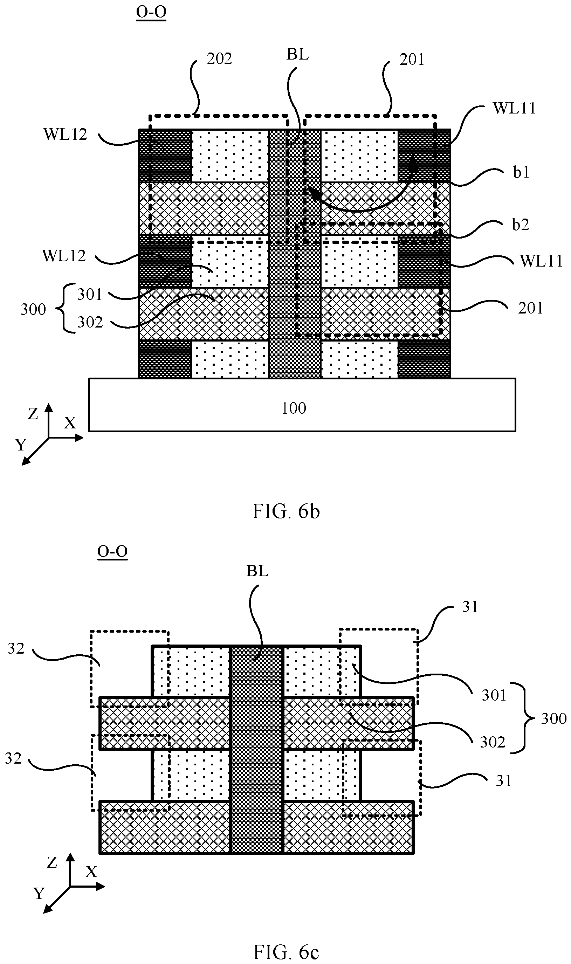

The second interlayer word line WL12 is disposed along the third direction Y, that is, the second interlayer word line WL12 may be parallel to the first interlayer word line WL11. As shown in FIG. 6b (a sectional view taken along a dashed line O-O in FIG. 6a), the second interlayer word line WL12 is in contact with the first interlayer dielectric layer 301 and the ferroelectric material layer 302.

In the embodiments of this application, in order to make the first interlayer word line WL11 in contact with the first interlayer dielectric layer 301 and the ferroelectric material layer 302, the stacked structure 30 may further have a first groove 31, as shown in FIG. 6c. The first groove 31 may be provided on the composite layer 300 along the third direction Y. In some embodiments of this application, the first groove 31 may be provided on the first interlayer dielectric layer 301. For example, a wet etching process may be used to remove a part of the material of the first interlayer dielectric layer 301 to form the first groove 31. In this case, for the first interlayer word line WL11, as shown in FIG. 6b, disposed in the first groove 31 along the third direction Y, a surface of the first interlayer word line WL11 parallel to the substrate 100 is in contact with the ferroelectric material layer 302, and a surface of the first interlayer word line WL 11 parallel to the second direction Z is in contact with the first interlayer dielectric layer 301.

Similarly, in order to make the second interlayer word line WL12 in contact with the first interlayer dielectric layer 301 and the ferroelectric material layer 302, the stacked structure 30 may further have a second groove 32, as shown in FIG. 6c. The second groove 32 may be provided on the composite layer 300 along the third direction Y. In some embodiments of this application, the second groove 32 may be provided on the first interlayer dielectric layer 301. In this case, for the second interlayer word line WL 12, as shown in FIG. 6b, disposed in the second groove 32 along the third direction Y, a surface of the second interlayer word line WL12 parallel to the substrate 100 is in contact with the ferroelectric material layer 302, and a surface of the second interlayer word line WL12 parallel to the second direction Z is in contact with the first interlayer dielectric layer 301.

In this way, along the first direction X, the first groove 31 and the second groove 32 can be respectively located on two sides of the first interlayer dielectric layer 301 in the composite layer 300, so that the first interlayer word line WL11 and the second interlayer word line WL12 can be respectively located on two sides of the first interlayer dielectric layer 301 in the composite layer 300.

In this case, one second interlayer word line WL12, one bit line BL, and a part of the ferroelectric material layer between the second interlayer word line WL 12 and the bit line BL may constitute a second memory cell 202, as shown in FIG. 6b. As described above, each memory cell array 20 may have N×M second memory cells 202. In this way, one first memory cell 201 and one second memory cell 202 in the same layer of stacked structure 30 can share one bit line BL. This can simplify the structure of the ferroelectric memory 10 while improving the storage capacity of the ferroelectric memory 10. In addition, it can be learned from the above that the S memory cell arrays 20 in the ferroelectric memory 10 are sequentially arranged on the substrate 100 along the first direction X. Therefore, the second memory cells 202 in the ferroelectric memory 10 are arranged in an S×N×M three-dimensional array.

On this basis, in order to avoid crosstalk between upper and lower first memory cells 201 in FIG. 6b, in some embodiments of this application, a surface treatment process, such as proton exchange or another technical means, is used to treat an upper surface or a lower surface of the ferroelectric material layer 302, so that the ferroelectricity of the treated upper surface b1 (or the lower surface b2) is weakened or eliminated, while the lower surface b2 (or the upper surface b1) of the ferroelectric material layer 302 that has not undergone the surface treatment process maintains normal ferroelectricity because its ferroelectricity has not weakened or eliminated. In this way, the upper surface b1 and the lower surface b2 of the ferroelectric material layer 302 can have different ferroelectricity.

In this case, when the first memory cell 201 is working, the first interlayer word line WL11 in contact with the ferroelectric material layer 302 is in a contact connection to the lower surface (or the upper surface) of the ferroelectric material layer 302 having normal ferroelectricity, but is not in a contact connection to the upper surface (or the lower surface) of the ferroelectric material layer 302 having ferroelectricity weakened or eliminated. Therefore, it can be ensured that a current path in each first memory cell 201 is shown in FIG. 6b. A current from the first interlayer word line WL11 passes through the ferroelectric material layer 302 and then is transmitted to the bit line BL. Alternatively, a current from the bit line BL passes through the ferroelectric material layer 302 and then is transmitted to the first interlayer word line WL11. The reduction of crosstalk between upper and lower second memory cells 202 is the same as that described above, and details are not repeated herein.

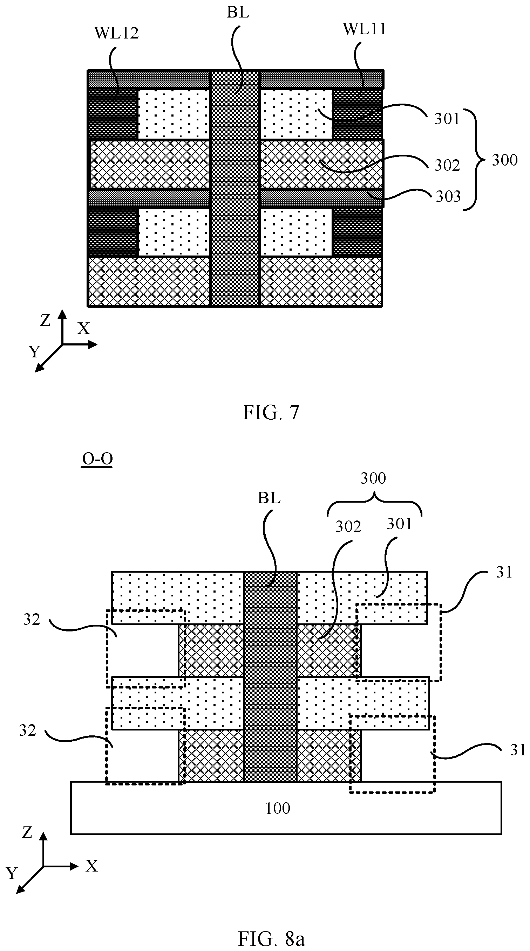

Alternatively, in some other embodiments of this application, as shown in FIG. 7, the composite layer 300 may further include a second interlayer dielectric layer 303. The second interlayer dielectric layer 303 may be disposed between the first interlayer dielectric layer 301 and the ferroelectric material layer 302, and is in contact with the first interlayer dielectric layer 301, the ferroelectric material layer 302, the first interlayer word line WL11, and the second interlayer word line WL12. A material of the second interlayer dielectric layer 303 may be an insulating material, such as silicon nitride (Si₃N₄), and is different from the material of the first interlayer dielectric layer 301 (SiO₂). In this way, the second interlayer dielectric layer 303 is not to be etched away when the wet etching process is used to etch the first interlayer dielectric layer 301 to form the first groove 31 and the second groove 32. In this case, the upper and lower first memory cells 201 (or the upper and lower second memory cells 202) can be isolated by the second interlayer dielectric layer 303 to avoid crosstalk between them.

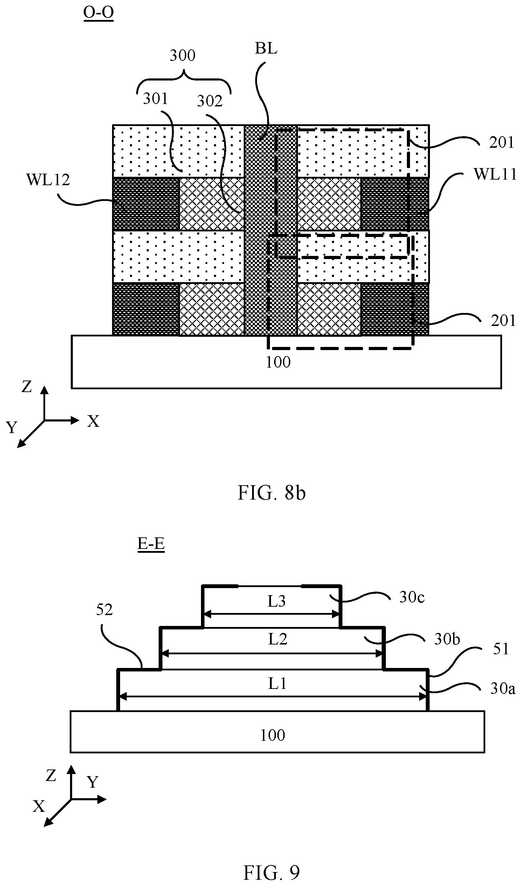

The above description is given by using an example in which a part of the material of the first interlayer dielectric layer 301 is removed to form the first groove 31 and the second groove 32 on the composite layer 300. In some other embodiments of this application, as shown in FIG. 8a, the first groove 31 may be provided on the ferroelectric material layer 302. For example, a wet etching process may be used to remove a part of the material of the ferroelectric material layer 302 to form the first groove 31. In this case, for the first interlayer word line WL11, as shown in FIG. 8b, disposed in the first groove 31 along the third direction Y, a surface of the first interlayer word line WL 11 parallel to the substrate 100 is in contact with the first interlayer dielectric layer 301, and a surface of the first interlayer word line WL 11 parallel to the second direction Z is in contact with the ferroelectric material layer 302.

Similarly, as shown in FIG. 8a, the second groove 32 may be provided on the ferroelectric material layer 302. In this case, for the second interlayer word line WL 12, as shown in FIG. 8b, disposed in the second groove 32 along the third direction Y, a surface of the second interlayer word line WL 12 parallel to the substrate 100 is in contact with the first interlayer dielectric layer 301, and a surface of the second interlayer word line WL 12 parallel to the second direction Z is in contact with the ferroelectric material layer 302.

In this way, along the first direction X, the first groove 31 and the second groove 32 can be respectively located on two sides of the ferroelectric material layer 302 in the composite layer 300, so that the first interlayer word line WL 11 and the second interlayer word line WL12 can be respectively located on two sides of the ferroelectric material layer 302 in the composite layer 300. In addition, as shown in FIG. 8b, the upper and lower first memory cells 201 (or the upper and lower second memory cells 202) can be isolated by the first interlayer dielectric layer 301, so that crosstalk between them can be avoided.

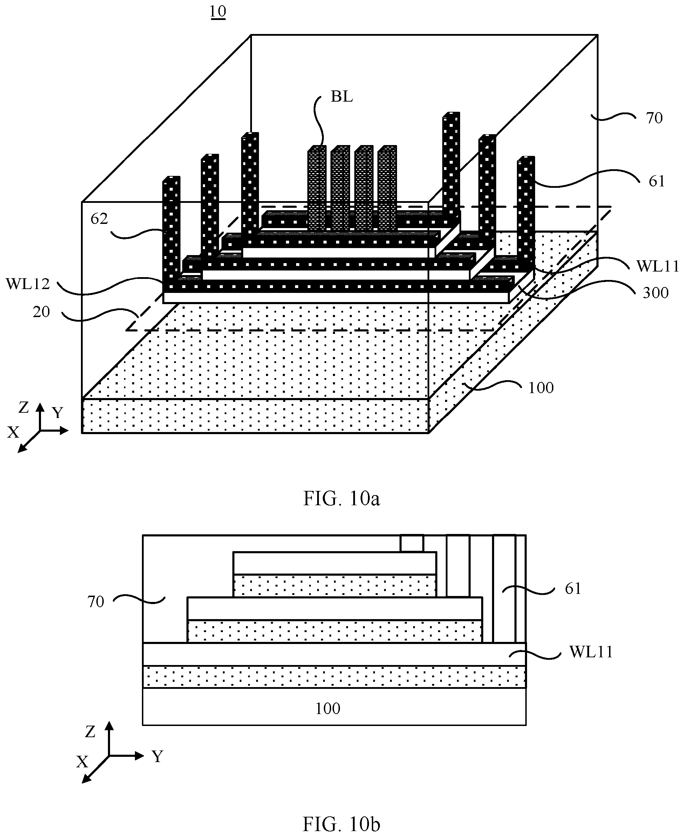

As can be learned from the above, each memory cell array 20 includes stacked structures 30 stacked along the second direction Z, and each stacked structure 30 includes one first interlayer word line WL 11 and one second interlayer word line WL 12. In this case, in order to be able to provide electrical signals to the first interlayer word line WL 11 and the second interlayer word line WL 12 in different interlayer structures 30, as shown in FIG. 9 (a sectional view taken along a dashed line E-E in FIG. 2c), the lengths (the length direction is parallel to the third direction Y) of the N stacked structures, such as a stacked structure 30a, a stacked structure 30b, and a stacked structure 30c, decrease sequentially along the direction away from the substrate 100, for example, L1 > L2 > L3. In this way, a first stepped structure 51 can be formed at one end of the N stacked structures 30 along the third direction Y, and a second stepped structure 52 at the other end. In this case, for two adjacent stacked structures (such as 30c and 30b) on the substrate 100, the length L3 of the upper stacked structure 30c is less than the length L2 of the lower stacked structure 30b, so that a part of each of the first interlayer word line WL11 and the second interlayer word line WL12 in each layer of stacked structure can be exposed as shown in FIG. 10a, without being blocked by the composite layer 300 of an upper layer of stacked structure.

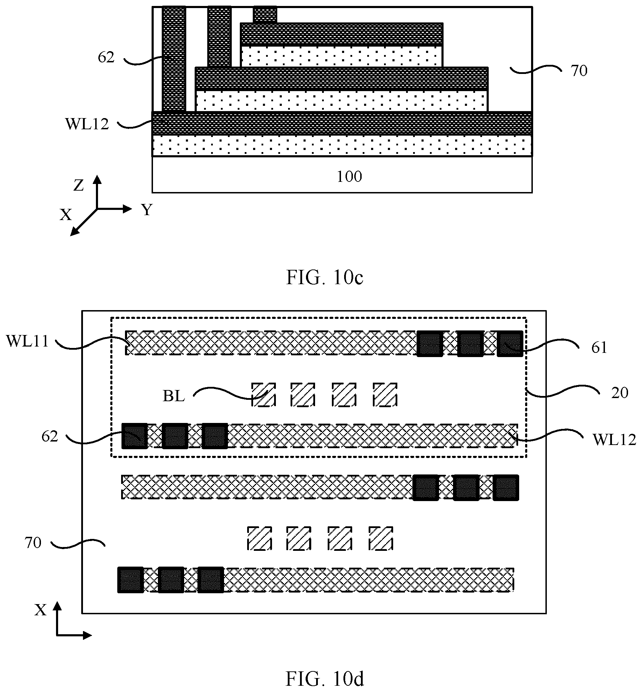

On this basis, as shown in FIG. 10a, the memory cell array 20 may further include N first word line vias 61 and N second word line vias 62. When the ferroelectric memory 10 further includes a fill dielectric layer 70 covering the S memory cell arrays 20 and the substrate 100. As shown in FIG. 10b, the first word line vias 61 may extend through the fill dielectric layer 70 along the second direction Z. Similarly, as shown in FIG. 10c, the second word line vias 62 may extend through the fill dielectric layer 70 along the second direction Z. The fill dielectric layer 70 can protect the S memory cell arrays 20. A material of the fill dielectric layer 70 may be SiO₂.

In addition, as shown in FIG. 10b, the N first word line vias 61 may be electrically connected to the first interlayer word lines WL 11 in N steps of the first stepped structure 51 (as shown in FIG. 9), respectively. As shown in FIG. 10c, the N second word line vias 62 may be electrically connected to the second interlayer word lines WL 12 in N steps of the second stepped structure 52 (as shown in FIG. 9), respectively.

In this way, the first interlayer word lines WL 11 electrically connected to the plurality of first memory cells 201, as shown in FIG. 10d (a top view taken along the second direction Z in FIG. 10a), can be led out from the first word line vias 61 on the right side in FIG. 10b. The second interlayer word lines WL 12 electrically connected to the plurality of second memory cells 202 can be led out from the second word line vias 62 on the left side in FIG. 10b.

It should be noted that, in FIG. 10d, the first interlayer word line WL11, the second interlayer word line WL12, and the BL covered by the fill dielectric layer 70 are indicated by dashed lines.

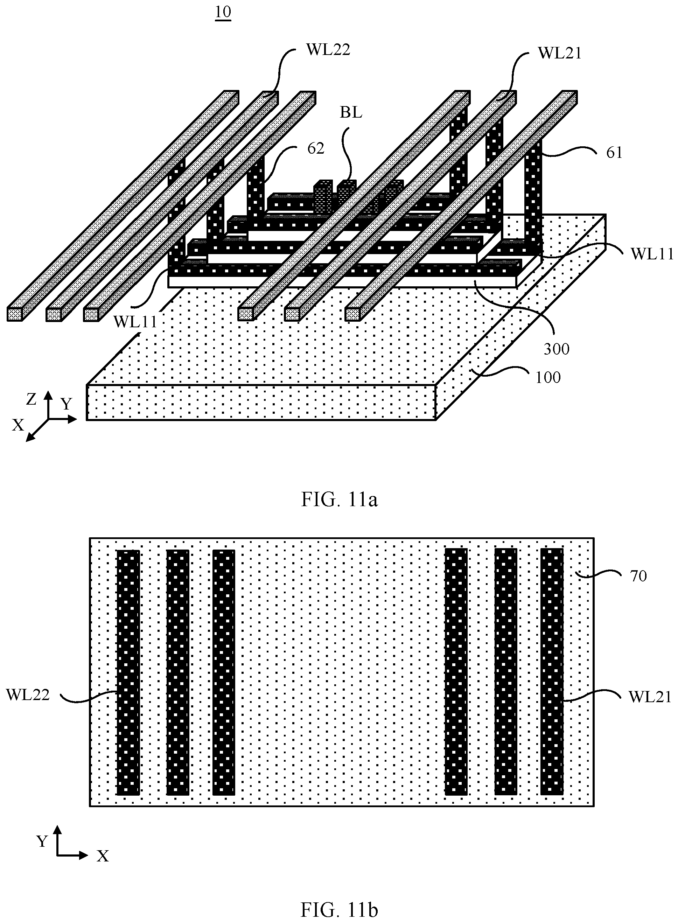

On this basis, as shown in FIG. 11a, the ferroelectric memory 10 further includes N first global word lines WL21 and N second global word lines WL22. When the ferroelectric memory 10 includes the fill dielectric layer 70, as shown in FIG. 11b, the first global word lines WL21 and the second global word lines WL22 may be provided on an outer surface of the fill dielectric layer 70. The outer surface of the fill dielectric layer 70 may be a surface parallel to the substrate 100 (that is, parallel to the XY plane) and away from the substrate 100.

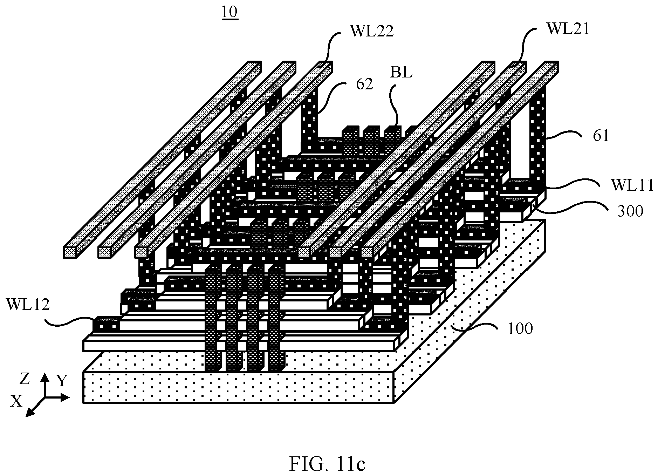

On this basis, the N first global word lines WL21 are electrically connected to the N first word line vias 61, as shown in FIG. 11c, of each memory cell array 20, respectively. Specifically, each first global word line WL21 may be electrically connected to the first word line vias 61 located on the same step (N steps in total) in all (for example, S) memory cell arrays 20. In this case, each first global word line WL21 may provide a strobe signal to the first word line vias 61 located on the same step in each memory cell array 20.

Similarly, the N second global word lines WL22 are electrically connected to the N second word line vias 62, as shown in FIG. 11c, of each memory cell array 20, respectively. Specifically, each second global word line WL22 may be electrically connected to the second word line vias 62 located on the same step (N steps in total) in all (for example, S) memory cell arrays 20. S ≥ 2, and S is an integer.

In this case, each second global word line WL22 may provide a strobe signal to the second word line vias 62 located on the same step in each memory cell array 20. In this way, the first global word line WL21 and the second global word line WL22 can respectively control the first memory cell 201 and the second memory cell 202 in the same memory cell array 20. The two memory cells share the bit line BL.

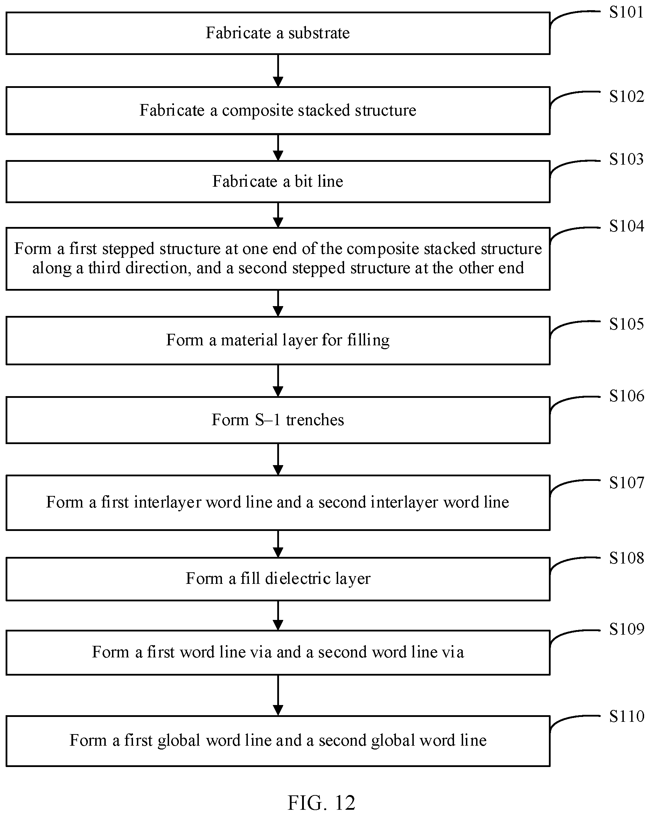

The following illustrates a fabrication method for the ferroelectric memory 10 shown in FIG. 11c. The fabrication method, as shown in FIG. 12, includes S101 to S110.

S101: Fabricate a substrate 100.

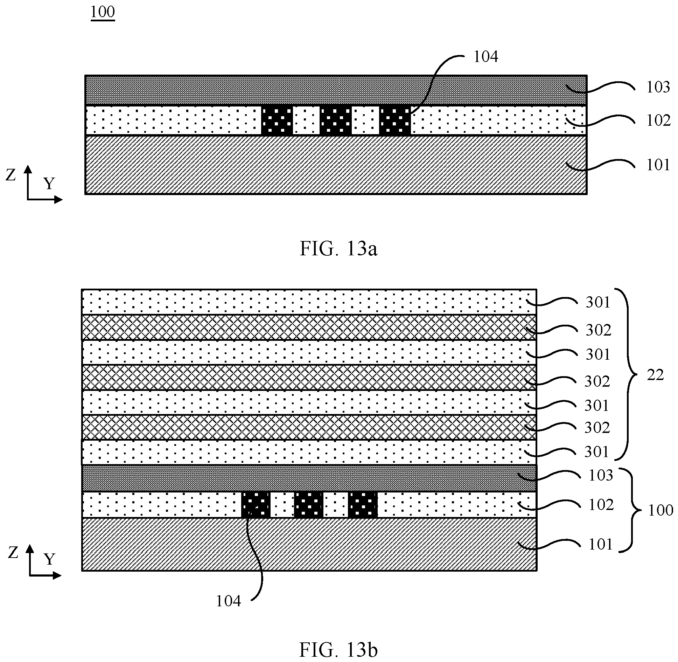

For example, the control circuit for supplying a voltage to the first global word line WL21, the second global word line WL22, and the bit line BL is provided in the substrate 100, and the fabrication of the substrate 100 includes, as shown in FIG. 13a, using a front-end-of-line (front-end-of-line, FEOL) process of the fabrication of a complementary metal oxide semiconductor (complementary metal oxide semiconductor, CMOS) to fabricate transistors in a semiconductor substrate 101 to form the control circuit. Next, the remaining process performed on the semiconductor substrate 101 may be referred to as a back-end-of-line (back-end-of-line, BEOL) process of the COMS fabrication.

Specifically, an isolation metal oxide layer, such as SiO₂, may be deposited on the semiconductor substrate 101 in which the control circuit is fabricated, to form an isolation dielectric layer 102 shown in FIG. 13a. The isolation dielectric layer 102 may completely cover the semiconductor substrate 101. Next, a metal plug process, such as a tungsten plug process, is used to prepare a plurality of metal plugs 104, that is, tungsten plugs, in the isolation dielectric layer 102. Then, an upper surface of the isolation dielectric layer 102 in which the metal plugs 104 are formed is polished, to improve the surface flatness.

Next, an etching barrier layer 103 is fabricated on the upper surface of the isolation dielectric layer 102. The etching barrier layer 103 may completely cover the isolation dielectric layer 102 and the metal plugs 104. A material of the etching barrier layer 103 may be Si₃N₄. The etching barrier layer 103 can protect the metal plugs 104 covered by the etching barrier layer 103 and the control circuit in the semiconductor substrate 101 to prevent the subsequent etching process from damaging the metal plugs 104 and the control circuit.

S102: Fabricate a composite stacked structure 22.

As shown in FIG. 13b, a plurality of first interlayer dielectric layers 301 and a plurality of ferroelectric material layers 302 are alternately stacked in sequence on the substrate 100 along the second direction Z perpendicular to the substrate 100, to form the composite stacked structure 22.

The thickness of the first interlayer dielectric layer 301 may be adjusted from tens to hundreds of nanometers as required. The material of the first interlayer dielectric layer 301 is as described above, and details are not repeated herein. The first interlayer dielectric layer 301 is used to be bonded to a single crystal film made of the ferroelectric material, that is, the ferroelectric material layer 302. It should be noted that the foregoing surface treatment process may be performed on the to-be-bonded ferroelectric material layer 302 before (or after) the bonding to the first interlayer dielectric layer 301, so that ferroelectricity of a treated lower surface (or upper surface) of the ferroelectric material layer 302 is weakened or eliminated. In addition, surfaces of the ferroelectric material layers 302 in the composite stacked structure 22 to be subjected to the surface treatment process are the same. For example, the upper surfaces of all the ferroelectric material layers 302 may be subjected to the surface treatment process, or the lower surfaces of all the ferroelectric material layers 302 may be subjected to the surface treatment process, so that crosstalk between any two adjacent upper and lower first memory cells 201 (or second memory cells 202) can be avoided.

Based on this, in order to improve the bonding strength of the first interlayer dielectric layer 301 and the ferroelectric material layer 302 that are adjacent to each other, the upper surface of the first interlayer dielectric layer 301 needs to have a high flatness. For example, a roughness of its upper surface may be less than 0.5 nm. In addition, the thickness of the ferroelectric material layer 302 may be adjusted from tens to hundreds of nanometers as required. The material of the ferroelectric material layer 302 is as described above, and details are not repeated herein.

S103: Fabricate a bit line BL.

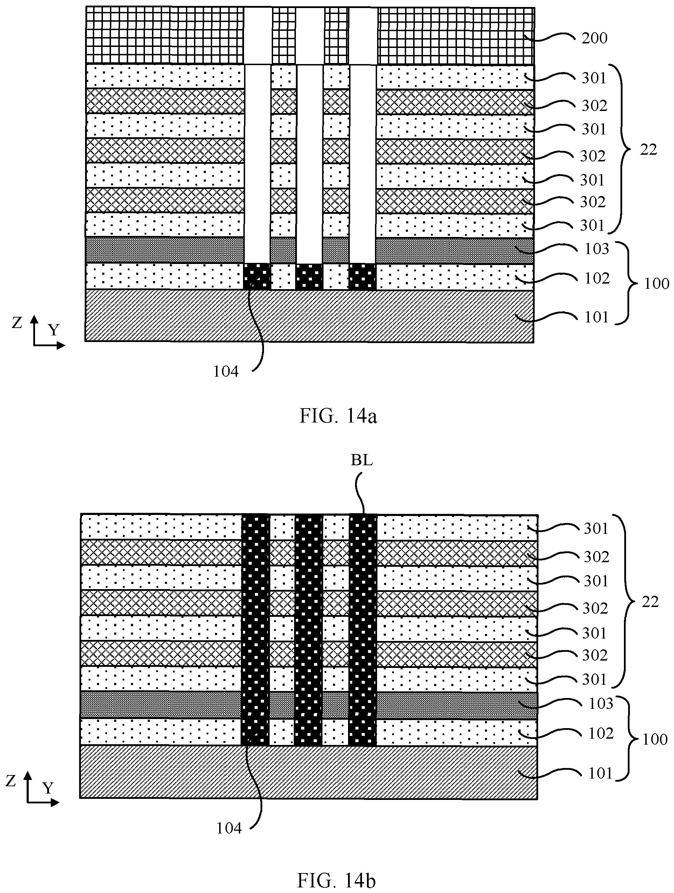

As shown in FIG. 14a, a mask layer 200 is formed on the upper surface of the composite stacked structure 22. The mask layer 200 may be formed by applying and curing a photoresist with ultraviolet light. Alternatively, a layer of hard film is deposited, and then a hard mask (hard mask, HM) layer is fabricated through a photolithography process. Then, a dry etching process, such as a reactive ion etching (reactive ion etching, RIE) process or an inductively coupled plasma etching (inductively coupled plasma, ICP) process, is performed on the composite stacked structure 22 by using the mask layer 200. The material, in the composite stacked structure 22, corresponding to opening positions of the mask layer 200 is removed until the metal plugs 104 are exposed by etching.

Next, as shown in FIG. 14b, the mask layer 200 is removed, and a hole formed by removing the material in the composite stacked structure 22 is filled with a metal material. For example, a tungsten plug process is used to form a via (Via), for use as a bit line BL. Each bit line BL may be electrically connected to one metal plug 104 in the isolation dielectric layer 102. In this way, the control circuit in the semiconductor substrate 101 can be electrically connected to the bit line BL through the metal plug 104.

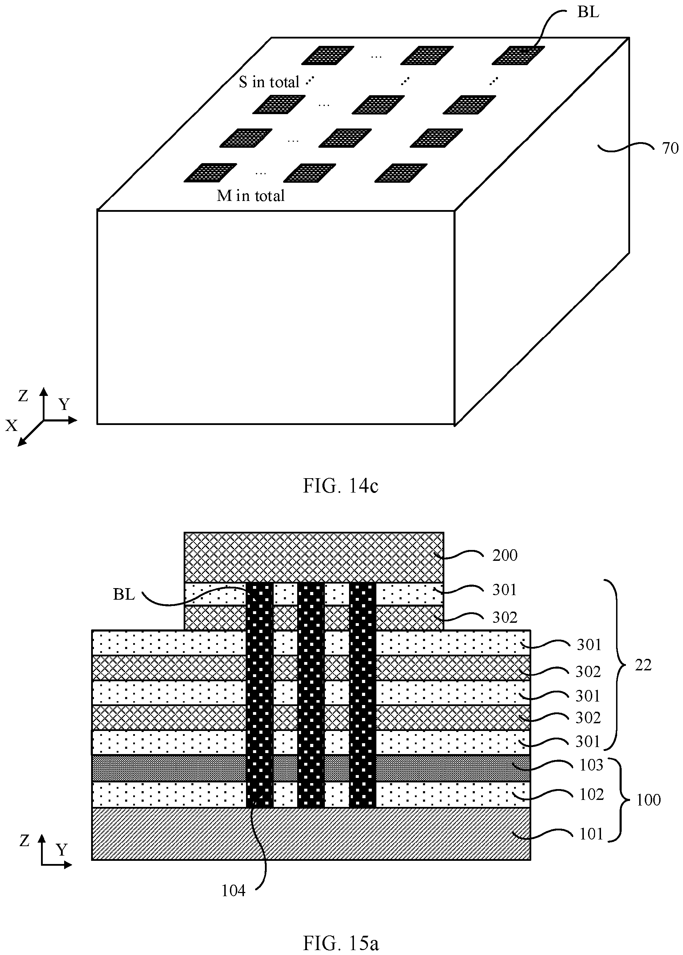

In this case, when S memory cell arrays 20 need to be provided in the ferroelectric memory 10, as shown in FIG. 14c, S×M bit lines BLs extending through the composite stacked structure 22 may be formed when S103 is performed. Every M BLs correspond to one memory cell array 20. In this way, the bit lines BLs of all the memory cell arrays 20 in the ferroelectric memory 10 can be formed in one via fabrication process.

S104: Form a first stepped structure 51 at one end of the composite stacked structure 22 along the third direction Y, and a second stepped structure 52 at the other end.

The foregoing mask layer fabrication process is used to fabricate a new mask layer 200 shown in FIG. 15a, and then the foregoing dry etching process is used to etch one first interlayer dielectric layer 301 and one ferroelectric material layer 302 from top to bottom along the third direction Y, to form a stepped structure.

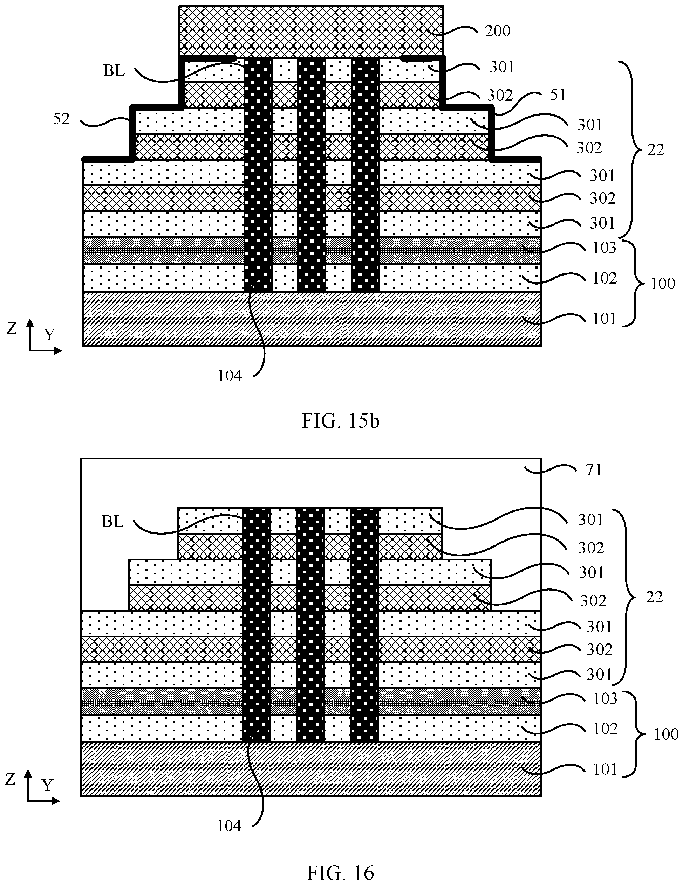

Next, the foregoing etching process is continued, and one first interlayer dielectric layer 301 and one ferroelectric material layer 302 that are adjacent to each other are etched each time. Therefore, as shown in FIG. 15b, the first stepped structure 51 may be formed at one end of the composite stacked structure 22 along the third direction Y, and the second stepped structure 52 at the other end. The number of steps of each of the first stepped structure 51 and the second stepped structure 52 is N, and the foregoing etching process needs to be performed N-1 times.

S105: Form a material layer 71 for filling.

The mask layer 200 is removed to form a material layer 71, as shown in FIG. 16, which is then polished. The material layer 71 covers the substrate 100 and the composite stacked structure having the first stepped structure 51 and the second stepped structure 52. A material of the material layer 71 may be a material having a large difference in wet etching rate from the first interlayer dielectric layer 301 and the ferroelectric material layer 302, for example, may be polysilicon (PolySi). In this way, it can be ensured that the first stepped structure 51 and the second stepped structure 52 are not affected when the first interlayer dielectric layer 301 or the ferroelectric material layer 302 is wet-etched in the subsequent process.

S106: Form S-1 trenches 21.

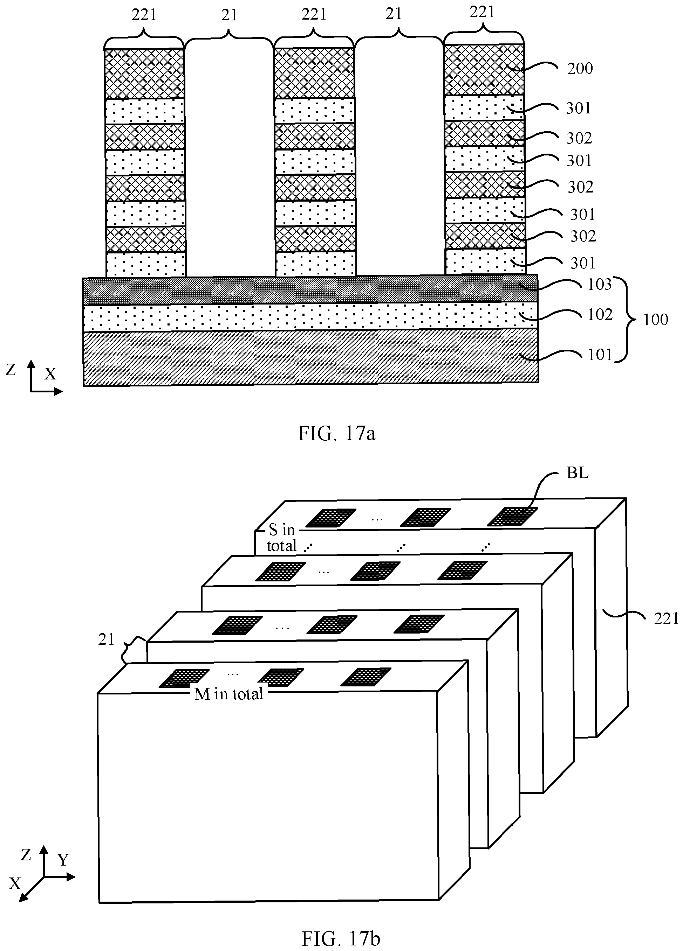

A mask layer 200 is fabricated on the structure formed after S105 is performed, and then the composite stacked structure 22 is dry-etched until the etching barrier layer 103 is etched, so that the S-1 trenches 21, as shown in FIG. 17a, extending through the composite stacked structure 22 and arranged along the first direction parallel to the substrate can be formed. The composite stacked structure 22 may be partitioned into S sub-composite stacked structures 221 by the S-1 trenches. As shown in FIG. 17b, M bit lines BLs extend through each sub-composite stacked structure 221.

S107: Form a first interlayer word line WL11 and a second interlayer word line WL12.

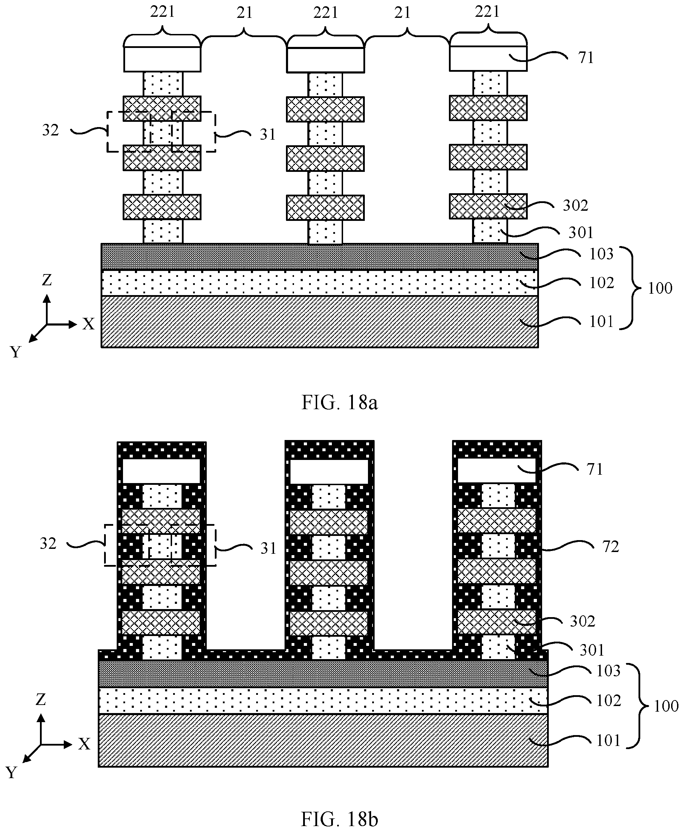

The mask layer 200 in FIG. 17a is removed. Then, as shown in FIG. 18a, a wet etching process is used to etch the first interlayer dielectric layers 301 on two sides of the trench 21, to etch away a part of each of the plurality of first interlayer dielectric layers 301 on a first side and a second side of each trench, so that a plurality of first grooves 31 and a plurality of second grooves 32 are respectively formed on two sides of the sub-composite stacked structure 221. Each first groove 31 is disposed along the third direction Y, and each second groove 32 is disposed along the third direction Y

It should be noted that the above description is given by using an example in which the first interlayer dielectric layer 301 is removed to form the first groove 31 and the second groove 32. In some other embodiments of this application, alternatively, wet etching may be used to remove a plurality of ferroelectric material layers 302 to form the first grooves 31 and the second grooves 32.

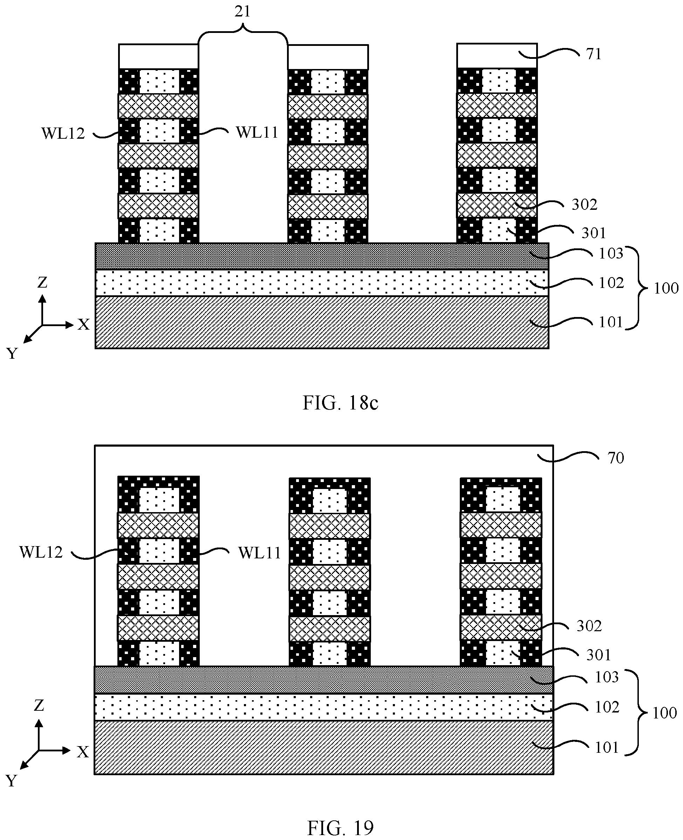

Next, as shown in FIG. 18b, a deposition process is used to fill the first groove 31 and the second groove 32 with a metal material 72, such as titanium nitride (TiN) or metal tungsten (W). Next, the metal material in the first groove 31 and the second groove 32 is retained, and the remaining metal material may be removed by an etching process. In this way, as shown in FIG. 18c, N first interlayer word lines WL11 arranged along the second direction Z can be formed on the first side of each trench 21. Because each first groove 31 is disposed along the third direction Y, the first interlayer word line WL11 in the first groove 31 is also disposed along the third direction Y, and is in contact with the first interlayer dielectric layer 301 and the ferroelectric material layer 302. Similarly, N second interlayer word lines WL 12 arranged along the second direction Z can be formed while the first interlayer word lines WL 11 are formed. Because each second groove 32 is disposed along the third direction Y, the second interlayer word line WL12 in the second groove 32 is also disposed along the third direction Y, and is in contact with the first interlayer dielectric layer 301 and the ferroelectric material layer 302.

In this way, the first interlayer word lines WL11 and the second interlayer word lines WL12 of all the memory cell arrays 20 in the ferroelectric memory 10 can be formed in one metal filling and etching process.

S108: Form a fill dielectric layer 70.

The material layer 71 in FIG. 18c is removed, and then oxide is filled in. The oxide, for example, may be the same as the material of the first interlayer dielectric layer 301, both of which are SiO₂, to form the fill dielectric layer 70 shown in FIG. 19. The fill dielectric layer 70 covers the substrate 100 and the structure formed on the substrate 100 after S107 is performed, and a part of the material of the fill dielectric layer 70 may be filled in the trench 21 formed in S106. In this case, the part of the material of the fill dielectric layer 70 in the trench 21 can space apart the memory cell arrays 20 respectively located on two sides of the trench 21.

S109: Form a first word line via 61 and a second word line via 62.

Next, on the side of the first stepped structure 51 of each sub-composite stacked structure 221, a via fabrication process is used to form N first word line vias 61, as shown in FIG. 10b, extending through at least the fill dielectric layer 70. The N first word line vias 61 are electrically connected to the first interlayer word lines WL11 in N steps of the first stepped structure 51, respectively. In this way, the first interlayer word line WL 11 on each step of the first stepped structure 51 is electrically connected to one first word line via 61.

While the first word line vias 61 are formed, N second word line vias 62, as shown in FIG. 10b, extending through at least the fill dielectric layer 70 are formed on the side of the second stepped structure 52 of each sub-composite stacked structure 221. The N second word line vias 62 are electrically connected to the second interlayer word lines WL12 in N steps of the second stepped structure 52, respectively. In this way, the second interlayer word line WL12 on each step of the second stepped structure 52 is electrically connected to one second word line via 62.

In this way, in all the memory cell arrays 20 of the ferroelectric memory 10, the first word line vias 61 for leading out the first interlayer word lines WL11 and the second word line vias 62 for leading out the second interlayer word lines WL 12 can be formed in one via fabrication process.

S110: Form a first global word line WL21 and a second global word line WL22.

As shown in FIG. 11b, N first global word lines WL21 and N second global word lines WL22 are formed on an outer surface of the fill dielectric layer 70 parallel to the substrate 100. Through the metal interconnect process, as shown in FIG. 11a, the N first global word lines WL21 may be electrically connected to the N first word line vias 61 in each sub-composite stacked structure 221, respectively; and the N second global word lines WL22 may be electrically connected to the N second word line vias 62 in each sub-composite stacked structure 221, respectively.

In conclusion, during the fabrication of the ferroelectric memory 10 shown in FIG. 11c, even if the number of memory cell arrays 20 arranged along the first direction X in the ferroelectric memory 10 increases, the memory cell arrays 20 can be spaced apart by using one process of fabrication the trenches 21. In addition, the first interlayer word lines WL 11 and the second interlayer word lines WL 12 in each memory cell array 20 can be formed in one metal filling and etching process. Therefore, during the fabrication of one memory cell array 20 on the substrate 100, the remaining S-1 memory cell arrays 20 can be fabricated on the substrate 100 at the same time. In this way, it is possible to avoid repeating a set of processes such as photolithography, etching, deposition, and metal interconnect for each memory cell array 20, thereby simplifying fabrication processes.

### Example 2:

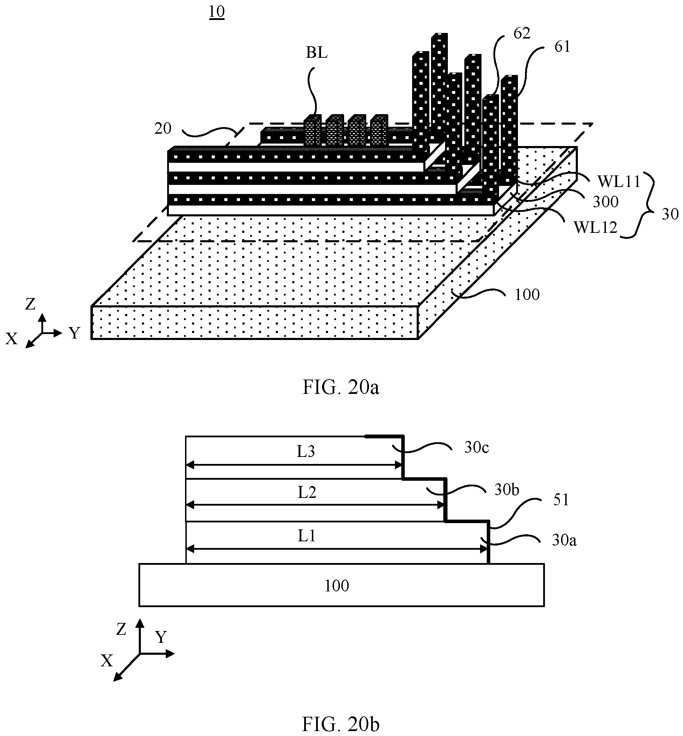

In this example, which is the same as Example 1, as shown in FIG. 20a, each stacked structure 30 in each memory cell array 20 of the ferroelectric memory 10 may include the composite layer 300, one first interlayer word line WL 11, and one second interlayer word line WL 12. The structures and fabrication methods of the composite layer 300, the first interlayer word line WL11, and the second interlayer word line WL12 are the same as those described above, and details are not repeated herein.

A difference from Example 1 lies in that, as shown in FIG. 20b, the lengths (the length direction is parallel to the third direction Y) of the N stacked structures, such as a stacked structure 30a, a stacked structure 30b, and a stacked structure 30c, decrease sequentially along the direction away from the substrate 100, for example, L1 > L2 > L3. In this way, the first stepped structure 51 can be formed at one end of the N stacked structures 30 along the third direction Y, and the N stacked structures 30 are flush at the other end.

In this case, the length L3 of the upper stacked structure 30c is less than the length L2 of the lower stacked structure 30b, so that a part of each of the first interlayer word line WL 11 and the second interlayer word line WL 12 in each layer of stacked structure can be exposed as shown in FIG. 20a, without being blocked by the composite layer 300 of an upper layer of stacked structure.

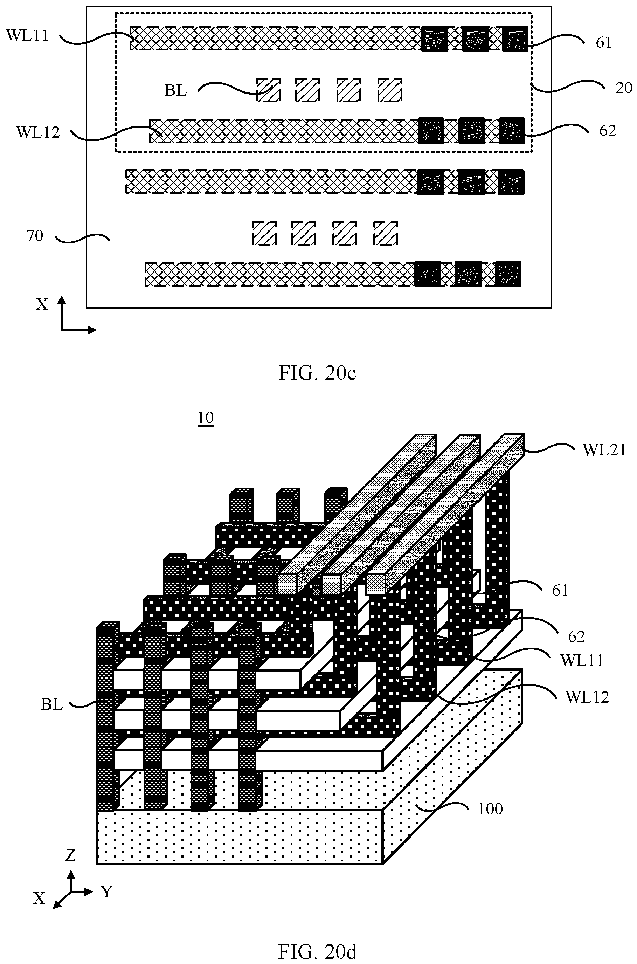

Based on this, as shown in FIG. 20a, the memory cell array 20 may further include N first word line vias 61 and N second word line vias 62. The N first word line vias 61 may be electrically connected to the first interlayer word lines WL 11 in N steps of the first stepped structure 51 (as shown in FIG. 20b), respectively. The N second word line vias 62 may be electrically connected to the second interlayer word lines WL 12 in the N steps of the first stepped structure 51, respectively. In this way, the first interlayer word lines WL 11 electrically connected to the plurality of first memory cells 201, as shown in FIG. 20c, can be led out from the first word line vias 61 on the right side in FIG. 20c. The second interlayer word lines WL 12 electrically connected to the plurality of second memory cells 202 can be led out from the second word line vias 62 on the right side in FIG. 20c.

On this basis, as shown in FIG. 20d, the ferroelectric memory 10 further includes N first global word lines WL21. The N first global word lines WL21 are electrically connected to the N first word line vias 61 of each memory cell array 20, respectively. Specifically, each first global word line WL21 may be electrically connected to the first word line vias 61 located on the same step (N steps in total) in all (for example, S) memory cell arrays 20. In this case, each first global word line WL21 may provide a strobe signal to the first word line vias 61 located on the same step in each memory cell array 20.

Similarly, the N first global word lines WL21 are further electrically connected to the N second word line vias 62 of each memory cell array 20, respectively. Specifically, each first global word line WL21 may further be electrically connected to the second word line vias 62 located on the same step (N steps in total) in all (for example, S) memory cell arrays 20. In this case, each first global word line WL21 may further provide a strobe signal to the second word line vias 62 located on the same step in each memory cell array 20. In this way, the first memory cell 201 and the second memory cell 202 located in the same layer in each memory cell array 20 can be electrically connected by using the first global word line WL21. In this case, both the memory cell array 20 composed of the plurality of first memory cells 201 and the memory cell array 20 composed of the plurality of second memory cells 202 can work, and the direction of polarization of the ferroelectric material layer 302 does not need to be obtained in advance, thereby lowering requirements for the direction of polarization of the ferroelectric material layer 302.

A fabrication method for the ferroelectric memory 10 shown in FIG. 20d provided in this example is the same as that described above, except that when S104 shown in FIG. 12 is performed, the first stepped structure 51 is formed only at one end of the composite stacked structure 22 along the third direction Y, while no stepped structure needs to be formed at the other end. In addition, when S109 is performed, both the first word line via 61 and the second word line via 62 need to be fabricated on the side of the first stepped structure 51. When S110 is performed, only the first global word line WL21 needs to be fabricated at a position corresponding to the first stepped structure 51.

### Example 3:

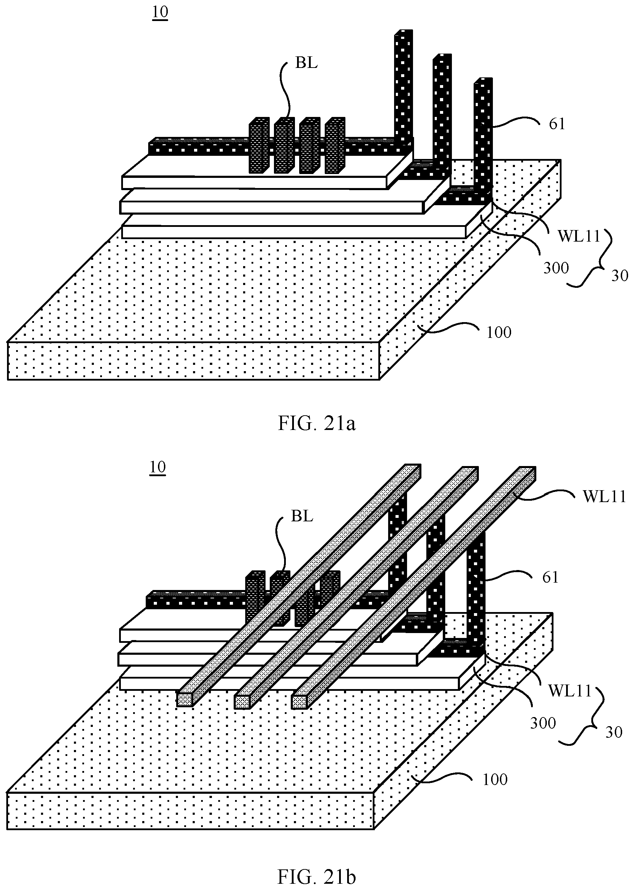

In this example, as shown in FIG. 21a, each stacked structure 30 in each memory cell array 20 of the ferroelectric memory 10 may include the composite layer 300 and one first interlayer word line WL11. The structures and fabrication methods of the composite layer 300 and the first interlayer word line WL11 are the same as those described above, and details are not repeated herein.

In this case, the lengths of the N stacked structures 30a decrease sequentially along the direction away from the substrate 100. In this way, the first stepped structure 51 can be formed at one end of the N stacked structures 30 along the third direction Y, and the N stacked structures 30 are flush at the other end (as shown in FIG. 20b). The technical effect of the sequentially decreasing lengths of the N stacked structures 30a is the same as that described above, and details are not repeated herein.

Based on this, as shown in FIG. 21a, the memory cell array 20 may further include N first word line vias 61. The N first word line vias 61 may be electrically connected to the first interlayer word lines WL11 in N steps of the first stepped structure 51 (as shown in FIG. 20b), respectively. In this way, the first interlayer word lines WL 11 electrically connected to the plurality of first memory cells 201 can be led out from the first word line vias 61 on the right side in FIG. 21a.

Similar to that described above, as shown in FIG. 21b, the ferroelectric memory 10 further includes N first global word lines WL21. The N first global word lines WL21 are electrically connected to the N first word line vias 61 of each memory cell array 20, respectively. In this case, each first global word line WL21 may provide a strobe signal to the first word line vias 61 located on the same step in each memory cell array 20.

A fabrication method for the ferroelectric memory 10 shown in FIG. 21b provided in this example is the same as that described above, except that when S104 shown in FIG. 12 is performed, the first stepped structure 51 is formed only at one end of the composite stacked structure 22 along the third direction Y, while no stepped structure needs to be formed at the other end. In addition, when S109 is performed, only the first word line via 61 needs to be formed. When S110 is performed, only the first global word line WL21 needs to be fabricated at a position corresponding to the first stepped structure 51.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A ferroelectric memory, comprising:
a substrate; and
S memory cell arrays, sequentially arranged on the substrate along a first direction parallel to the substrate, wherein a trench is provided between two adjacent memory cell arrays, S≥2, and S is an integer; and each memory cell array comprises:
N stacked structures and M bit lines, the N stacked structures are sequentially stacked along a second direction perpendicular to the substrate, each stacked structure comprises a composite layer and a first interlayer word line, the composite layer comprises a first interlayer dielectric layer and a ferroelectric material layer that are stacked, the first interlayer word line is disposed along a third direction and is in contact with the first interlayer dielectric layer and the ferroelectric material layer, the third direction is parallel to the substrate and perpendicular to the first direction, wherein N ≥ 2, and N is an integer; and
each of the M bit lines extends through the composite layers of the N stacked structures along the second direction, wherein M ≥ 2, and M is an integer.

2. The ferroelectric memory according to claim 1, wherein
the stacked structure further comprises a second interlayer word line, the second interlayer word line is disposed along a third direction and is in contact with the first interlayer dielectric layer and the ferroelectric material layer, and the first interlayer word line and the second interlayer word line are respectively located on two sides of the composite layer along the first direction.

3. The ferroelectric memory according to claim 2, wherein a first stepped structure is formed at one end of the N stacked structures along the third direction, and a second stepped structure at the other end, the lengths of the N stacked structures decrease sequentially along the direction away from the substrate, and the length direction of the stacked structure is parallel to the third direction;
the memory cell array further comprises:
N first word line vias, wherein the N first word line vias are electrically connected to the first interlayer word lines in N steps of the first stepped structure, respectively; and N second word line vias, wherein the N second word line vias are electrically connected to the second interlayer word lines in N steps of the second stepped structure respectively; and
the ferroelectric memory further comprises:
N first global word lines, wherein the N first global word lines are electrically connected to the N first word line vias of each memory cell array, respectively; and
N second global word lines, wherein the N second global word lines are electrically connected to the N second word line vias of each memory cell array, respectively.

4. The ferroelectric memory according to claim 2, wherein a first stepped structure is formed at one end of the N stacked structures along the third direction, and a second stepped structure at the other end, the lengths of the N stacked structures decrease sequentially along the direction away from the substrate, and the length direction of the stacked structure is parallel to the third direction;
the memory cell array further comprises:
N first word line vias, wherein the N first word line vias are electrically connected to the first interlayer word lines in N steps of the first stepped structure, respectively; and
N second word line vias, wherein the N second word line vias are electrically connected to the second interlayer word lines in N steps of the first stepped structure, respectively; and
the ferroelectric memory further comprises:
N first global word lines, the N first global word lines are electrically connected to the N first word line vias of each memory cell array, respectively, and the N first global word lines are further electrically connected to the N second word line vias of each memory cell array, respectively.

5. The ferroelectric memory according to claim 1, wherein a first stepped structure is formed at one end of the N stacked structures along the third direction, and a second stepped structure at the other end, the lengths of the N stacked structures decrease sequentially along the direction away from the substrate, and the length direction of the stacked structure is parallel to the third direction;
the memory cell array further comprises N first word line vias, wherein the N first word line vias are electrically connected to the first interlayer word lines in N steps of the first stepped structure, respectively; and
the ferroelectric memory further comprises N first global word lines, wherein the N first global word lines are electrically connected to the N first word line vias of each memory cell array, respectively.

6. The ferroelectric memory according to any one of claims 1 to 5, wherein the stacked structure has a first groove, the first groove is provided on the composite layer along the third direction, and the first interlayer word line is located in the first groove.

7. The ferroelectric memory according to claim 6, wherein the first groove is provided on the first interlayer dielectric layer, a surface of the first interlayer word line parallel to the substrate is in contact with the ferroelectric material layer, and a surface of the first interlayer word line parallel to the second direction is in contact with the first interlayer dielectric layer

8. The ferroelectric memory according to claim 7, wherein composite layer further comprises a second interlayer dielectric layer; the second interlayer dielectric layer is disposed between the first interlayer dielectric layer and the ferroelectric material layer, and is in contact with the first interlayer dielectric layer, the ferroelectric material layer, and the first interlayer word line; and
a material of the first interlayer dielectric layer is different from that of the second interlayer dielectric layer

9. The ferroelectric memory according to claim 8, wherein the first groove is provided on the ferroelectric material layer, a surface of the first interlayer word line parallel to the substrate is in contact with the first interlayer dielectric layer, and a surface of the first interlayer word line parallel to the second direction is in contact with the ferroelectric material layer.

10. The memory according to claim 9, wherein the stacked structure has a second groove, the second groove is provided on the composite layer along the third direction, the first groove and the second groove are respectively located on two sides of the composite layer along the third direction, and the second interlayer word line is located in the second groove.

11. The ferroelectric memory according to any one of claims 1 to 10, wherein
the substrate comprises:
a semiconductor substrate, wherein a control circuit is provided in the semiconductor substrate;
an isolation dielectric layer, covering the semiconductor substrate;
an etching barrier layer, covering the isolation dielectric layer; and
S×M metal plugs, extending through the isolation dielectric layer, wherein each metal plug is configured to electrically connect the control circuit to a bit line.

12. The ferroelectric memory according to any one of claims 1 to 11, wherein
a material of the first interlayer dielectric layer comprises oxide; and
a material of the ferroelectric material layer comprises: lithium niobate, lithium tantalate, bismuth ferrite, lead zirconate titanate, barium titanate, strontium tantalate, hafnium dioxide, or the like.

13. The ferroelectric memory according to claim 3, wherein the ferroelectric memory further comprises a fill dielectric layer covering the S memory cell arrays and the substrate;
the first word line vias and the second word line vias extend through the fill dielectric layer along the second direction; and
the first global word lines and the second global word lines are provided on may be provided on an outer surface of the fill dielectric layer parallel to the substrate.

14. The ferroelectric memory according to claim 13, wherein a material of the fill dielectric layer is the same as the material of the first interlayer dielectric layer.

15. The ferroelectric memory according to claim 2, wherein the memory cell array comprises:
N×M first memory cells, wherein each first memory cell comprises one first interlayer word line, one bit line, and a part of the ferroelectric material layer between the first interlayer word line; and
N×M second memory cells, wherein each second memory cell comprises one second interlayer word line, one bit line, and a part of the ferroelectric material layer between the second interlayer word line.

16. An electronic device, comprising a circuit board and the ferroelectric memory according to any one of claims 1 to 15 disposed on the circuit board.

17. A fabrication method for a ferroelectric memory, wherein the fabrication method comprises:
alternately stacking a plurality of first interlayer dielectric layers and a plurality of ferroelectric material layers in sequence on a substrate along a second direction perpendicular to the substrate, to form a composite stacked structure;
forming S×M vias extending through the composite stacked structure as bit lines, wherein S ≥ 2, M ≥ 2, and S and M are integers;
forming S-1 trenches extending through the composite stacked structure and arranged along a first direction parallel to the substrate, wherein the composite stacked structure is partitioned into S sub-composite stacked structures by the S-1 trenches, and M bit lines extend through each sub-composite stacked; and
forming N first interlayer word lines arranged along the second direction on a first side of each trench, wherein each first interlayer word line is disposed along a third direction and is in contact with the first interlayer dielectric layer and the ferroelectric material layer, N ≥ 2, and N is an integer; and the third direction is parallel to the substrate, and is perpendicular to the first direction.

18. The fabrication method for the ferroelectric memory according to claim 17, wherein
before the forming N first interlayer word lines arranged along the second direction on a first side of each trench, the fabrication method further comprises: removing a part of the material of the plurality of first interlayer dielectric layers or the plurality of ferroelectric material layers on the first side of each trench, to form N first grooves arranged along the second direction, wherein each first groove is disposed along the third direction; and
the forming N first interlayer word lines arranged along the second direction on a first side of each trench comprises: filling each first groove with a metal material to form the first interlayer word lines.

19. The fabrication method for the ferroelectric memory according to claim 18, wherein while the first grooves are formed, the fabrication method further comprises:
removing a part of the material of the plurality of first interlayer dielectric layers or the plurality of ferroelectric material layers on a second side of each trench, to form N second grooves arranged along the second direction, wherein each second groove is disposed along the third direction; and
while the first interlayer word lines are formed, the fabrication method further comprises: filling each second groove with a metal material to form N second interlayer word lines arranged along the second direction.

20. The fabrication method for the ferroelectric memory according to claim 19, wherein before the forming trenches, the method further comprises: forming a first stepped structure at one end of the composite stacked structure along the third direction, and forming a second stepped structure at the other end at the same time; and
after the forming first interlayer word lines and second interlayer word lines, the method further comprises:
forming a fill dielectric layer;
forming N first word line vias extending through at least the fill dielectric layer on the side of the first stepped structure of each sub-composite stacked structure, wherein the N first word line vias are electrically connected to the first interlayer word lines in N steps of the first stepped structure, respectively;
forming N second word line vias extending through at least the fill dielectric layer are formed on the side of the second stepped structure of each sub-composite stacked structure, wherein the N second word line vias are electrically connected to the second interlayer word lines in N steps of the second stepped structure, respectively; and
forming N first global word lines and N second global word lines an outer surface of the fill dielectric layer parallel to the substrate, wherein the N first global word lines are electrically connected to the N first word line vias in each sub-composite stacked structure, respectively, and the N second global word lines are electrically connected to the N second word line vias in each sub-composite stacked structure, respectively.
